# EUROPEAN PATENT APPLICATION

(11) **EP 4 838 302 A1**
(43) Date of publication of application: **11.11.2026**
(21) Application number: 26173169.9
(22) Date of filing: 17.04.2026
(51) Int. Cl.: G03F 7/00, G03F 7/40

(54) **METHOD OF FORMING PATTERN BY USING BLOCK COPOLYMER**

(30) Priority: 09.05.2025 KR 20250060437
(71) Applicant: Samsung Electronics Co., Ltd., Suwon-si, Gyeonggi-do 16677 (KR)
(72) Inventor: SHIN, Jinyong, 16677 Suwon-si (KR); KIM, Mooseong, 16677 Suwon-si (KR); NAM, Minsik, 16677 Suwon-si (KR); DO, Hyungwan, 16677 Suwon-si (KR); OH, Kyoungwhan, 16677 Suwon-si (KR); YUN, Sangho, 16677 Suwon-si (KR); LIM, Gyumin, 16677 Suwon-si (KR); CHOI, Jeonghee, 16677 Suwon-si (KR)
(74) Representative: Marks & Clerk LLP

(57) **Abstract**

A method of forming the pattern may include forming a cross pattern on an etch target layer by repeating, at least twice, operations of: forming a hardmask; forming a guide layer on the hardmask; forming, on the guide layer, a photoresist pattern having a plurality of openings; performing a surface treatment on regions of the guide layer exposed through the plurality of openings, and removing the photoresist pattern; forming a block copolymer layer on the guide layer after the surface treatment has been performed; forming a block pattern by selectively removing some blocks from a plurality of blocks that are self-assembled through phase separation of the block copolymer layer; forming a hardmask pattern by etching the hardmask using the block pattern as an etch mask, wherein the hardmask pattern may have a line-and-space pattern; and removing the block pattern and the guide layer.

## Description

### BACKGROUND

Inventive concepts relate to a method of forming a pattern, and more particularly, to a method of forming a pattern by using a block copolymer.

As the degree of integration of semiconductor devices has increased, the area occupied by each unit cell in a plan view has decreased. In response to the decrease in unit cell area, design rules utilizing a smaller nano-scale critical dimension (CD) in a range of several nanometers (nm) to tens of nm have been applied. Accordingly, there may be a need for technology for forming a fine line pattern having a nano-scale width, or a fine hole pattern having a nano-scale opening size.

### SUMMARY

Inventive concepts provide a method of forming a pattern, which enables relatively easy implementation of a fine pattern that may be used for manufacturing a highly integrated semiconductor device and may exceed resolution limits of a general photolithography process.

Aspects of inventive concepts are not limited to those mentioned above, and other aspects that are not mentioned will be clearly understood by those skilled in the art from the following description.

According to an aspect of inventive concepts, a method of forming a pattern may include: forming, on an etch target layer, a first hardmask and a first guide layer; forming, on the first guide layer, a first photoresist pattern having a plurality of first openings; performing a first surface treatment on regions of the first guide layer exposed through the plurality of first openings, and removing the first photoresist pattern; forming a first block copolymer layer on the first guide layer after the performing the first surface treatment has been performed; forming a first block pattern by selectively removing some blocks from a plurality of blocks that are self-assembled through phase separation of the first block copolymer layer; forming a first hardmask pattern by etching the first hardmask using the first block pattern as an etch mask, the first hardmask pattern having a plurality of first line patterns, and removing the first block pattern and the first guide layer; forming a second hardmask and a third hardmask on the first hardmask pattern, and forming a second guide layer on the third hardmask; forming, on the second guide layer, a second photoresist pattern having a plurality of second openings; performing a second surface treatment on regions of the second guide layer exposed through the plurality of second openings, and removing the second photoresist pattern; forming a second block copolymer layer on the second guide layer after the second surface treatment has been performed; forming a second block pattern by selectively removing some blocks from a plurality of blocks that are self-assembled through phase separation of the second block copolymer layer; forming a third hardmask pattern by etching the third hardmask using the second block pattern as an etch mask, the third hardmask pattern having a plurality of third line patterns crossing the plurality of first line patterns at a certain angle; forming a second hardmask pattern by a process that includes etching the second hardmask using the third hardmask pattern as an etch mask to form a plurality of second line patterns, wherein the forming the second hardmask pattern may include forming a mask pattern from the first hardmask pattern and the second hardmask pattern; and forming a cross pattern by etching the etch target layer using the mask pattern as an etch mask.

According to another aspect of inventive concepts, a method of forming a cross pattern may include: stacking N hardmask patterns on an etch target layer, where N may be an integer greater than or equal to 2, and where each of the N hardmask patterns may have a line-and-space pattern on the etch target layer, wherein K may be an integer between 1 and (N - 1), a Kth hardmask pattern may be among the N hardmask patterns, and the Kth hardmask pattern may be formed by operations of: forming a Kth hardmask; forming a guide layer on the Kth hardmask; forming, on the guide layer, a photoresist pattern having a plurality of openings; performing a surface treatment on regions of the guide layer exposed through the plurality of openings, and removing the photoresist pattern; forming a block copolymer layer on the guide layer after the surface treatment has been performed; forming a block pattern by selectively removing some blocks from a plurality of blocks that are self-assembled through phase separation of the block copolymer layer; forming the Kth hardmask pattern by etching the Kth hardmask using the block pattern as an etch mask, the Kth hardmask pattern having the line-and-space pattern; and removing the block pattern and the guide layer. The method may include forming a (K+1)th hardmask pattern on the Kth hardmask pattern, and forming a cross pattern on the etch target layer using the N hardmask patterns as an etch mask.

According to another aspect of inventive concepts, a semiconductor device may include a substrate and a capacitor structure, the substrate having a dummy region surrounding a cell region and a plurality of active regions in the cell region, the capacitor structure being electrically connected to the plurality of active regions, and the capacitor structure comprising lower electrodes, a capacitor dielectric layer, and an upper electrode. A method of manufacturing the semiconductor device may include forming the lower electrodes by etching a lower electrode forming layer using a cross pattern as an etch mask, wherein the cross pattern may be formed by repeating, at least twice, operations of: forming a hardmask; forming a guide layer on the hardmask; forming, on the guide layer, a photoresist pattern having a plurality of openings; performing a surface treatment on regions of the guide layer exposed through the plurality of openings, and removing the photoresist pattern; forming a block copolymer layer on the guide layer after the surface treatment has been performed; forming a block pattern by selectively removing some blocks from a plurality of blocks that are self-assembled through phase separation of the block copolymer layer; and forming a hardmask pattern by etching the hardmask using the block pattern as an etch mask, the hardmask pattern having a line-and-space pattern; and removing the block pattern and the guide layer.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIGS. 1 and 2 are plan views illustrating a pattern structure including a fine pattern formed by a method of forming a pattern, according to an embodiment;
FIGS. 3 and 4 are configuration diagrams schematically illustrating an extreme ultraviolet (EUV) exposure apparatus used in a method of forming a pattern, according to inventive concepts;
FIG. 5 is a diagram illustrating a first EUV mask used in a method of forming a pattern, according to inventive concepts;
FIG. 6 is a diagram illustrating a preliminary pattern formed by using the first EUV mask of FIG. 5;
FIG. 7 is a diagram illustrating a directed self-assembly (DSA) process for a rectification step of a block copolymer;
FIG. 8 is a diagram illustrating a pattern formed by using a block copolymer having undergone DSA, based on the preliminary pattern of FIG. 6;
FIG. 9 is a diagram illustrating a second EUV mask used in a method of forming a pattern, according to inventive concepts;
FIG. 10 is a diagram illustrating a pattern formed by using a block copolymer having undergone DSA, based on a preliminary pattern formed by using the second EUV mask of FIG. 9;
FIG. 11 is a flowchart illustrating a method of forming a pattern, according to an embodiment;
FIGS. 12 to 30 are diagrams illustrating a process sequence of a method of forming a pattern, according to an embodiment;
FIGS. 31 to 36 are diagrams illustrating a partial process sequence of a method of forming a pattern, according to another embodiment;
FIG. 37 is a flowchart illustrating a method of manufacturing a semiconductor device, according to an embodiment;
FIGS. 38 to 47 are diagrams illustrating a process sequence of a method of manufacturing a semiconductor device, according to an embodiment; and
FIGS. 48 to 50 are diagrams illustrating a partial process sequence of a method of manufacturing a semiconductor device, according to another embodiment.

### DETAILED DESCRIPTION OF THE EMBODIMENTS

Hereinafter, embodiments of inventive concepts will be described in detail with reference to the accompanying drawings.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., ±10%).

The notion that elements are "substantially the same" may indicate that the element may be completely the same and may also indicate that the elements may be determined to be the same in consideration of errors or deviations occurring during a process.

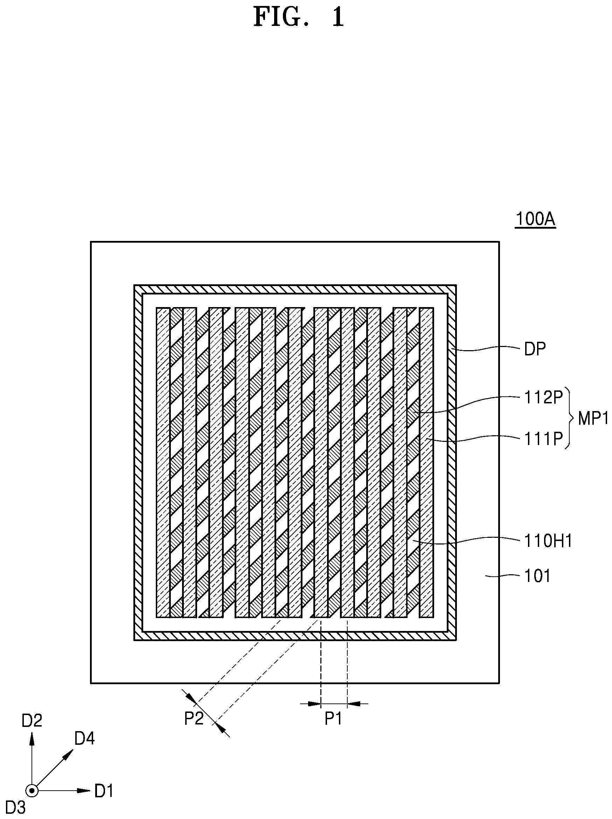

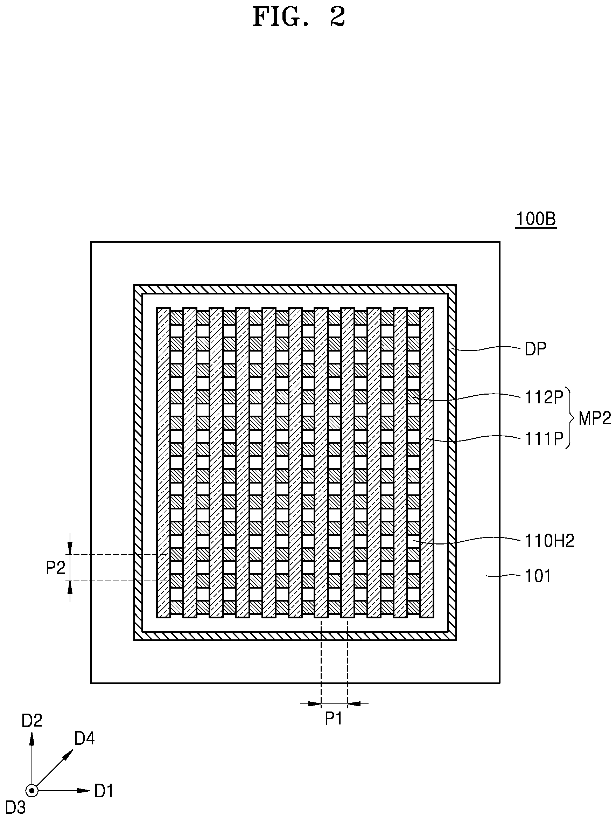

FIGS. 1 and 2 are plan views illustrating a pattern structure including a fine pattern formed by a method of forming a pattern, according to an embodiment.

Two directions that are parallel to an upper surface of a substrate 101 and cross each other are defined as a first direction D1 and a second direction D2. For example, the first direction D1 and the second direction D2 may be orthogonal to each other. Also, a direction perpendicular to the upper surface of the substrate 101 is defined as a third direction D3. Here, a direction having a certain angle between the first direction D1 and the second direction D2 is defined as a fourth direction D4. A direction indicated by an arrow in the drawing and an opposite direction thereof are described as the same direction. Hereinafter, the definition of such a direction is equally applied to all drawings.

Referring to FIGS. 1 and 2 together, a pattern structure 100A or 100B in which a mask pattern MP1 or MP2 and a dummy pattern DP surrounding the mask pattern MP1 or MP2 are formed on the substrate 101 is shown.

The substrate 101 may include a semiconductor material, for example, a group IV semiconductor, a group III-V compound semiconductor, or a group II-VI oxide semiconductor. For example, the group IV semiconductor may include silicon, germanium, or silicon germanium. Also, the substrate 101 may be provided as a bulk wafer, an epitaxial wafer, or a silicon-on-insulator (SOI) wafer.

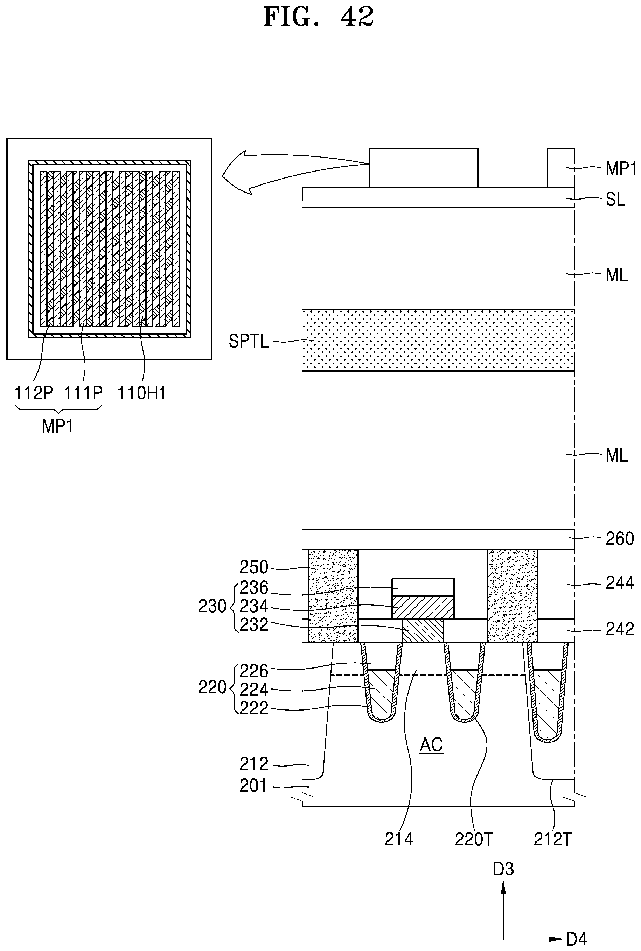

Although not shown, an etch target layer may be further formed on the substrate 101. The etch target layer may be an insulating layer, a conductive layer, or a semiconductor layer that is etched into a final target pattern. As shown, when formation of the etch target layer on the substrate 101 is omitted, a desired fine pattern may be directly formed on the substrate 101 by etching a portion of the substrate 101 by using the mask pattern MP1 or MP2 and the dummy pattern DP as etch masks. In other words, in some example embodiments, the etch target layer may correspond to the substrate 101, a layer (e.g., insulating layer, conductive layer, semiconductor layer) formed on the substrate and etched into a final target pattern, a multi-layer structure formed on the substrate and etched into a final target pattern (See FIGS. 42-43 for example), or a combination thereof. Hereinafter, for convenience of description, the etch target layer on the substrate 101 is omitted.

The pattern structure 100A or 100B may include the mask pattern MP1 or MP2, respectively, to be used for patterning a cell region on the substrate 101, and the dummy pattern DP to be used for patterning a dummy region surrounding the cell region. The cell region and the dummy region are regions arbitrarily divided for convenience of description, and the cell region and the dummy region may not be directly projected onto a semiconductor device.

A first hardmask pattern 111P and a second hardmask pattern 112P, which constitute the mask pattern MP1 or MP2, may be mesh patterns crossing each other, and the mask pattern MP1 or MP2 may be an etch mask for forming a final target pattern on the substrate 101. In some embodiments, a first hardmask pattern 111P may be formed first on the substrate 101, and a second hardmask pattern 112P may be formed later. The first hardmask pattern 111P and the second hardmask pattern 112P may include different materials, and may have different etch rates.

For example, the first hardmask pattern 111P or the second hardmask pattern 112P may include a carbon-based material. The first hardmask pattern 111P or the second hardmask pattern 112P may be a spin-on hardmask (SOH) including an amorphous carbon layer (ACL), a hydrocarbon compound having a carbon content of about 85 wt% to about 99 wt% based on the total weight, or a derivative thereof.

Also, for example, the first hardmask pattern 111P or the second hardmask pattern 112P may include plasma enhanced oxide (PEOX), tetraethyl orthosilicate (TEOS), boro TEOS (BTEOS), phosphorous TEOS (PTEOS), boro phospho TESO (BPTEOS), boro silicate glass (BSG), phospho silicate glass (PSG), boro phospho silicate glass (BPSG), etc.

The dummy pattern DP may be formed together with the mask pattern MP1 or MP2 as a portion thereof. For example, a portion of the dummy pattern DP may be formed during a process of forming the first hardmask pattern 111P, and another portion of the dummy pattern DP may be formed during a process of forming the second hardmask pattern 112P. Accordingly, the dummy pattern DP may include the same material as the material constituting the first hardmask pattern 111P and the second hardmask pattern 112P. Here, the dummy pattern DP is shown in the shape of a closed quadrangular line, but is not limited thereto.

In detail, in the pattern structure 100A of FIG. 1, the first hardmask pattern 111P may have a plurality of first line-and-space patterns, and the first lines may extend lengthwise in the second direction D2. Also, the second hardmask pattern 112P may have a plurality of virtual second line-and-space patterns, and the virtual second lines may extend lengthwise in the fourth direction D4. Here, the first lines and the virtual second lines may cross each other at a certain angle, and the certain angle may be greater than 0° and less than 180°. A first pitch P1 between the first lines may be in a range of about 12 nanometers (nm) to about 30 nm, and a second pitch P2 between the virtual second lines may be in a range of about 12 nm to about 30 nm.

In the pattern structure 100A of FIG. 1, the mask pattern MP1 may include a plurality of openings 110H1 exposing the upper surface of the substrate 101. The plurality of openings 110H1 may be spaced apart from each other at equal intervals, and may each have the same shape. For example, the plurality of openings 110H1 may each have a parallelogram shape, but are not limited thereto.

In detail, in the pattern structure 100B of FIG. 2, the first hardmask pattern 111P may have a plurality of first line-and-space patterns, and the first lines may extend lengthwise in the second direction D2. Also, the second hardmask pattern 112P may have a plurality of virtual second line-and-space patterns, and the virtual second lines may extend lengthwise in the first direction D1. Here, the first lines and the virtual second lines may be orthogonal to each other. A first pitch P1 between the first lines may be in a range of about 12 nm to about 30 nm, and a second pitch P2 between the virtual second lines may be in a range of about 12 nm to about 30 nm.

In the pattern structure 100B of FIG. 2, the mask pattern MP2 may include a plurality of openings 110H2 exposing the upper surface of the substrate 101. The plurality of openings 110H2 may be spaced apart from each other at equal intervals, and may each have the same shape. For example, the plurality of openings 110H2 may each have a rectangular shape, but are not limited thereto.

In the pattern structure 100A or 100B of the present embodiment, the mask pattern MP1 or MP2 and the dummy pattern DP on the substrate 101 may be formed by using an extreme ultraviolet (EUV) photolithography process and a phase separation process of a block copolymer. First, an EUV exposure apparatus for performing an EUV photolithography process is described.

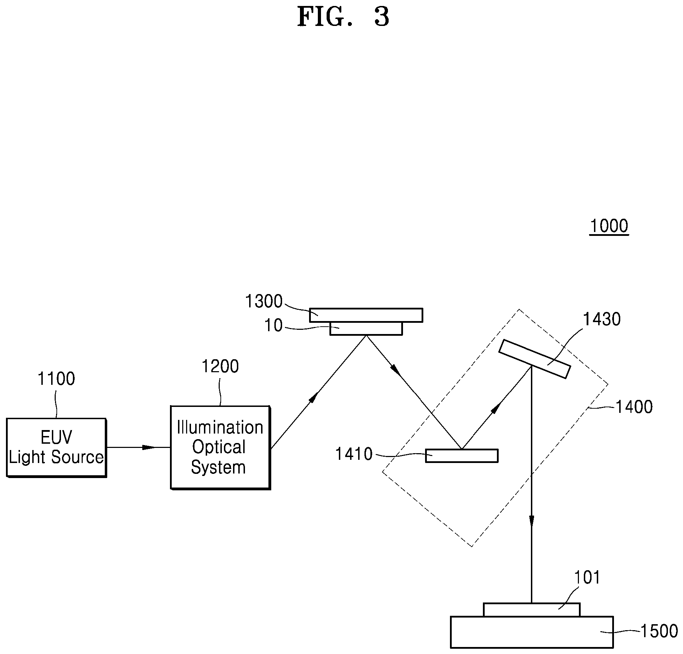

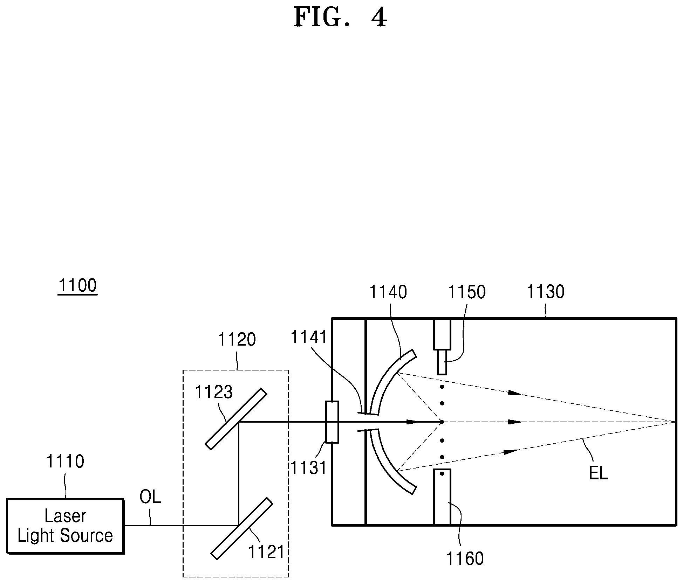

FIGS. 3 and 4 are configuration diagrams schematically illustrating an EUV exposure apparatus used in a method of forming a pattern, according to inventive concepts.

Referring to FIGS. 3 and 4 together, an EUV exposure apparatus 1000 may include an EUV light source 1100, an illumination optical system 1200, a reticle support 1300, a projection optical system 1400, and a substrate stage 1500.

The EUV light source 1100 may generate and output EUV light EL having a high energy density. For example, EUV light EL emitted from the EUV light source 1100 may have a wavelength of about 12 nm to about 30 nm, and in some embodiments, the EUV light EL may have a wavelength of 13.5 nm. The EUV light source 1100 may include a laser light source 1110, a transmission optical system 1120, a vacuum chamber 1130, a collector mirror 1140, a droplet generator 1150, and a droplet catcher 1160.

The laser light source 1110 may output a laser OL. For example, the laser light source 1110 may output a carbon dioxide laser. The laser OL output from the laser light source 1110 may be incident on a window 1131 of the vacuum chamber 1130 through a plurality of reflective mirrors 1121 and 1123 included in the transmission optical system 1120, and may be introduced into the vacuum chamber 1130.

An aperture 1141 through which the laser OL may pass may be formed in the center of the collector mirror 1140, and the laser OL may be introduced into the vacuum chamber 1130 through the aperture 1141 of the collector mirror 1140.

The droplet generator 1150 may generate droplets that interact with the laser OL to generate the EUV light EL, and may provide the droplets into the vacuum chamber 1130.

The droplet catcher 1160 may be located below the droplet generator 1150, and may be configured to catch droplets that have not reacted with the laser OL. The droplets provided from the droplet generator 1150 may react with the laser OL introduced into the vacuum chamber 1130 to generate the EUV light EL. The collector mirror 1140 may collect and reflect the EUV light EL, thereby emitting the EUV light EL to the illumination optical system 1200 arranged outside the vacuum chamber 1130.

The illumination optical system 1200 may include a plurality of reflective mirrors, and may transmit the EUV light EL emitted from the EUV light source 1100 to an EUV mask 10. For example, the EUV light EL emitted from the EUV light source 1100 may be reflected by a reflective mirror in the illumination optical system 1200, and may be incident on the EUV mask 10 arranged on the reticle support 1300.

The EUV mask 10 may be a reflective mask having a reflective region and a non-reflective (or intermediate reflective) region. The EUV mask 10 may include a reflective multilayer film formed on a mask substrate including a material having a low thermal expansion coefficient, such as silicon (Si), and an absorption pattern formed on the reflective multilayer film.

The EUV mask 10 reflects the EUV light EL incident through the illumination optical system 1200, and makes the EUV light EL be incident on the projection optical system 1400. The EUV mask 10 structures the light incident from the illumination optical system 1200 into projection light based on a mask pattern formed by the reflective multilayer film and the absorption pattern on the mask substrate, and makes the projection light be incident on the projection optical system 1400. The projection light may be structured through at least two diffraction orders due to the EUV mask 10. The projection light may be incident on the projection optical system 1400 while retaining information on the mask pattern of the EUV mask 10, and may pass through the projection optical system 1400 to form an image corresponding to the mask pattern of the EUV mask 10 on the substrate 101.

The projection optical system 1400 may include a plurality of reflective mirrors 1410 and 1430. In the drawing, two reflective mirrors 1410 and 1430 are shown in the projection optical system 1400, but this is for convenience of description, and the projection optical system 1400 may include more reflective mirrors.

The substrate 101 may be arranged on the substrate stage 1500. The substrate stage 1500 may move three-dimensionally. By movement of the substrate stage 1500, the substrate 101 may also move in the same direction as the substrate stage 1500.

An EUV photoresist pattern having the resolution of the EUV light EL may be formed on the substrate 101 by using the EUV exposure apparatus 1000, and the method of forming a pattern, according to inventive concepts, may be implemented by using the EUV photoresist pattern as an etch mask.

However, an EUV photoresist pattern close to the resolution limit may have significantly large line edge roughness (LER) and line width roughness (LWR). Accordingly, a rectification step using a block copolymer may be added to the method of forming a pattern, according to inventive concepts, to improve the LER and LWR of such a pattern. This aspect will be described below.

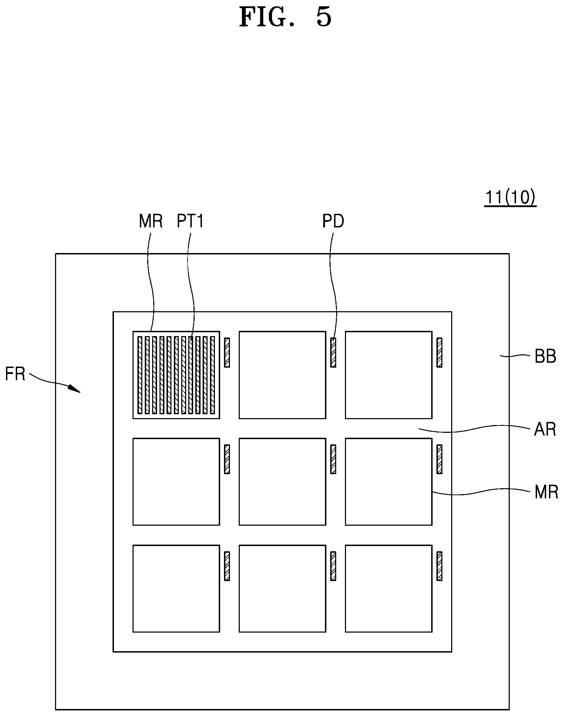

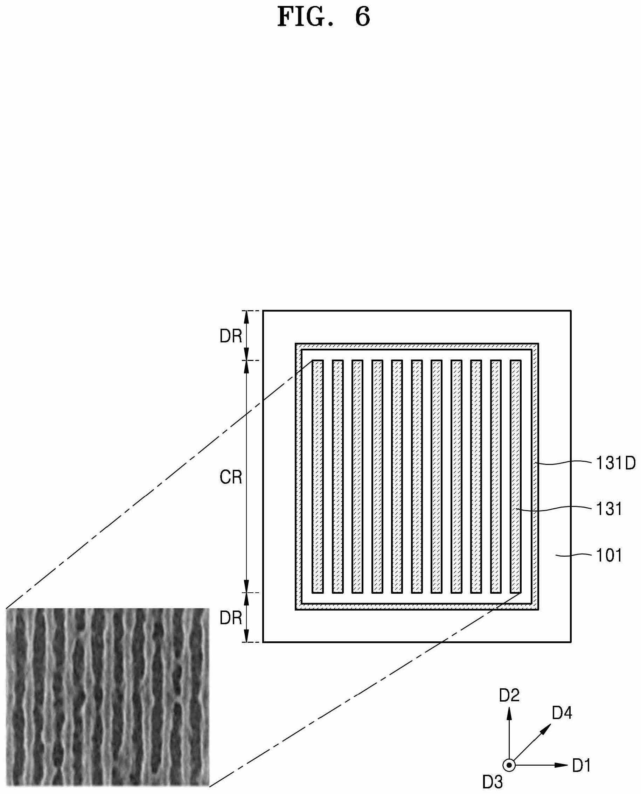

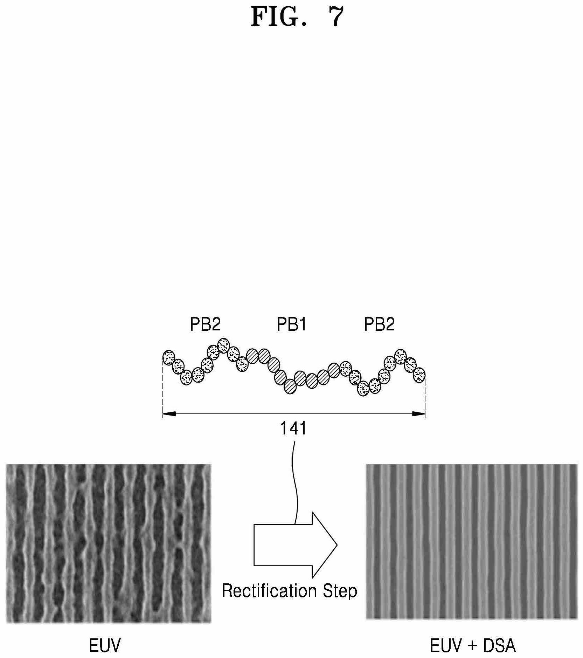

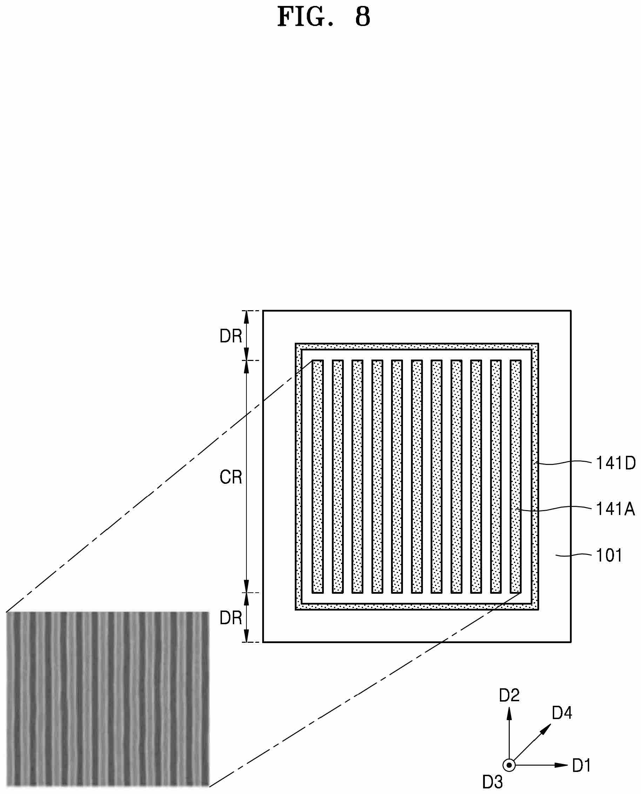

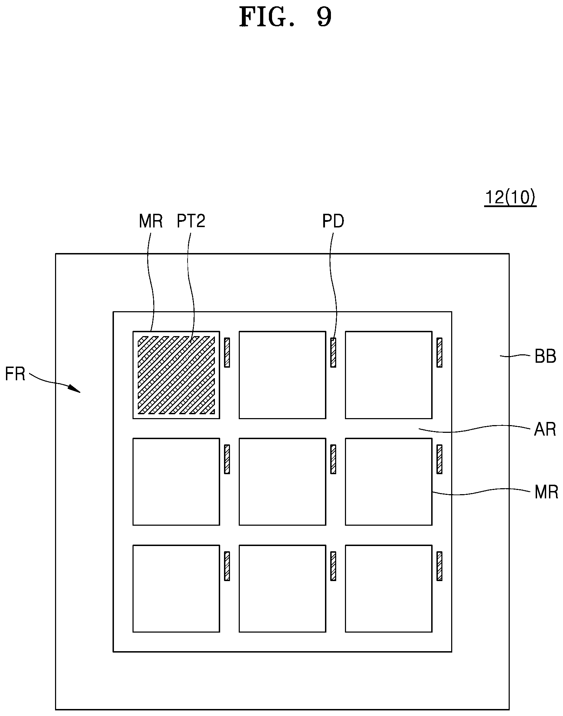

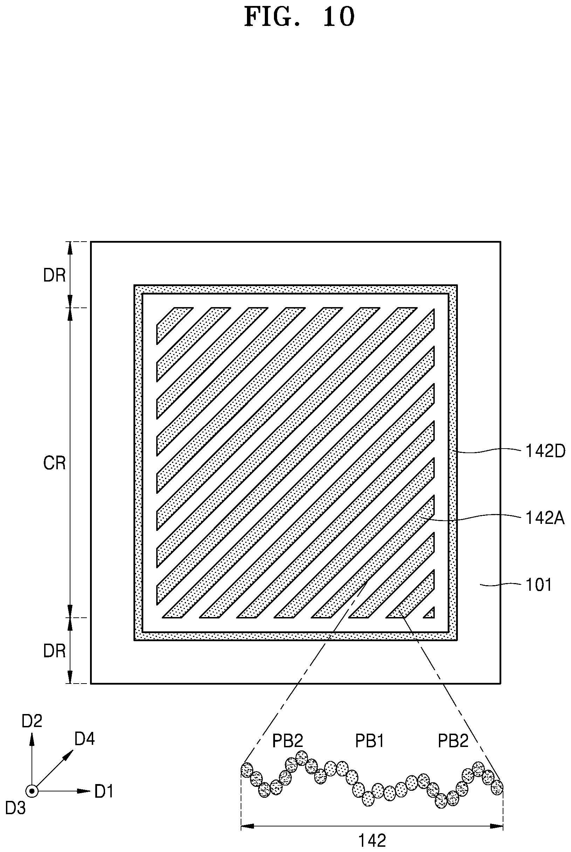

FIG. 5 is a diagram illustrating a first EUV mask used in a method of forming a pattern, according to inventive concepts. FIG. 6 is a diagram illustrating a preliminary pattern formed by using the first EUV mask of FIG. 5. FIG. 7 is a diagram illustrating a directed self-assembly (DSA) process for a rectification step of a block copolymer. FIG. 8 is a diagram illustrating a pattern formed by using a block copolymer having undergone DSA, based on the preliminary pattern of FIG. 6. FIG. 9 is a diagram illustrating a second EUV mask used in a method of forming a pattern, according to inventive concepts. FIG. 10 is a diagram illustrating a pattern formed by using a block copolymer having undergone DSA, based on a preliminary pattern formed by using the second EUV mask of FIG. 9.

Referring to FIGS. 5 to 10 in order, a model for improving the LER and LWR of an EUV photoresist pattern through a DSA process for a rectification step of a block copolymer is shown.

The EUV mask 10 is a reflective photomask for manufacturing a semiconductor device by transferring a pattern onto the substrate 101 through an exposure process. Here, the EUV mask 10 may include a first EUV mask 11 and a second EUV mask 12, depending on the order of use.

In some embodiments, the EUV mask 10 may be a reflective photomask based on a multilayer mirror structure, for use in an EUV photolithography process using an EUV wavelength range, for example, an exposure wavelength of about 13.5 nm.

A front surface FR of the EUV mask 10 may have a main pattern region MR for transferring a main pattern, which is required to form a unit device constituting a semiconductor device, to a cell region on the substrate 101, an auxiliary pattern region AR for transferring an auxiliary pattern to a dummy region on the substrate 101, and a black border region BB surrounding the main pattern region MR and the auxiliary pattern region AR. In some embodiments, the dummy region may correspond to a scribe lane region.

In FIG. 5, in the main pattern region MR of the first EUV mask 11, a first main pattern element PT1 constituting a main pattern for transferring a required pattern to the cell region on the substrate 101 may be formed. In the auxiliary pattern region AR, an auxiliary pattern element PD for transferring, to the scribe lane region on the substrate 101, an auxiliary pattern that is required in a manufacturing process of a semiconductor device but does not remain in a final product, for example, an align key pattern, instead of a pattern constituting the semiconductor device, may be formed. The black border region BB is a non-pattern region that does not include a pattern element.

In FIG. 6, a schematic diagram is shown of an EUV photoresist pattern transferred onto the substrate 101 by using the first EUV mask 11. The EUV photoresist pattern may include a first photoresist pattern 131 and a first dummy pattern 131D.

To form the first photoresist pattern 131 and the first dummy pattern 131D, an EUV photolithography process using the first EUV mask 11 may be performed. In detail, a cell region CR and a dummy region DR surrounding the cell region CR may be defined on the substrate 101. A plurality of transistors and a plurality of capacitors may be formed in the cell region CR. In the cell region CR, the first photoresist pattern 131 may be formed into a plurality of line-and-space patterns. In the dummy region DR, the first dummy pattern 131D in the shape of a closed quadrangular line may surround the first photoresist pattern 131.

However, the first photoresist pattern 131 that is close to the resolution limit may have significantly large LER and LWR. Accordingly, it is difficult to use the first photoresist pattern 131 as an etch mask.

In FIG. 7, a first block copolymer layer 141 that selectively reacts only with the first photoresist pattern 131 may be used. In the first block copolymer layer 141, a plurality of blocks having different repeating units may be arranged through phase separation. That is, through a DSA process for a rectification step of the first block copolymer layer 141, fluidity is imparted to polymer chains that are self-assembled into a plurality of first polymer blocks PB1 and a plurality of second polymer blocks PB2. Accordingly, the plurality of first polymer blocks PB1 may have improved LER and LWR, and the width of each of the plurality of first polymer blocks PB1 may be generally uniform.

In FIG. 8, the first block copolymer layer 141 may be patterned on the first photoresist pattern 131 through the DSA process. That is, in the cell region CR, a first block pattern 141A including the first polymer block PB1 may be formed as a plurality of line patterns extending in the second direction D2. In the dummy region DR, a first dummy pattern 141D in the shape of a closed quadrangular line may surround the first block pattern 141A.

In FIG. 9, in the main pattern region MR of the second EUV mask 12, a second main pattern element PT2 constituting a main pattern for transferring a required pattern to the cell region on the substrate 101 may be formed. Descriptions of the auxiliary pattern region AR and the black border region BB are substantially the same as those provided above. In other embodiments, the second EUV mask 12 may be used by rotating the first EUV mask 11 at a certain angle.

In FIG. 10, on the first hardmask pattern 111P (see FIG. 1) formed by using the first block pattern 141A as an etch mask, a second block copolymer layer 142 may be patterned through a DSA process with a rectification step on a second photoresist pattern (not shown). That is, in the cell region CR, a second block pattern 142A including the first polymer block PB1 may be formed as a plurality of line patterns extending in the fourth direction D4. In the dummy region DR, a second dummy pattern 142D in the shape of a closed quadrangular line may surround the second block pattern 142A.

As such, the pattern structure 100A or 100B (see FIGS. 1 and 2) may be formed by using the first block pattern 141A and the second block pattern 142A that cross each other at a certain angle. This aspect will be described in detail below.

Ultimately, in the pattern structure 100A or 100B formed by the method of forming a pattern, according to inventive concepts, by forming a pattern in which fine pitches, which are difficult to implement in a general photolithography process, are arranged in a repeating structure by using the first and second block copolymer layers 141 and 142, high-quality fine patterns with reduced LER and LWR in cross patterns may be designed in various shapes.

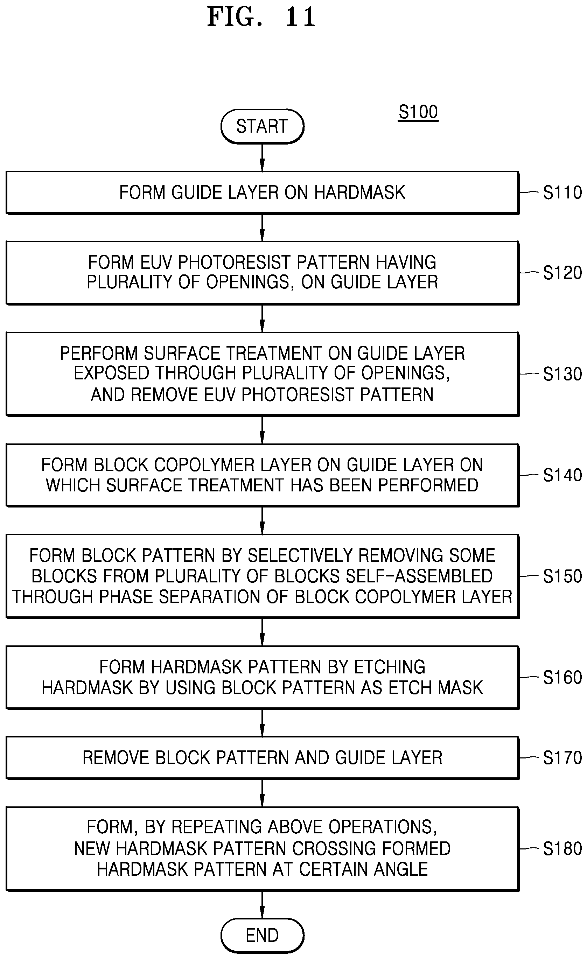

FIG. 11 is a flowchart illustrating a method of forming a pattern, according to an embodiment.

Referring to FIG. 11, a method S100 of forming a pattern may include a process sequence of first to eighth operations S110 to S180.

When an embodiment may be otherwise implemented, a certain process sequence may be performed differently from the described order. For example, two consecutively described processes may be performed substantially at the same time, or may be performed in an order opposite to the described order.

The method S100 of forming a pattern, according to inventive concepts, includes the first operation S110 of forming a guide layer on a hardmask, the second operation S120 of forming, on the guide layer, an EUV photoresist pattern having a plurality of openings, the third operation S130 of performing a surface treatment on the guide layer exposed through the plurality of openings, and removing the EUV photoresist pattern, the fourth operation S140 of forming a block copolymer layer on the guide layer on which the surface treatment has been performed, the fifth operation S150 of forming a block pattern by selectively removing some blocks from a plurality of blocks that are self-assembled through phase separation of the block copolymer layer, the sixth operation S160 of forming a hardmask pattern by etching the hardmask by using the block pattern as an etch mask, the seventh operation S170 of removing the block pattern and the guide layer, and the eighth operation S180 of forming, by repeating the above operations, a new hardmask pattern crossing the formed hardmask pattern at a certain angle.

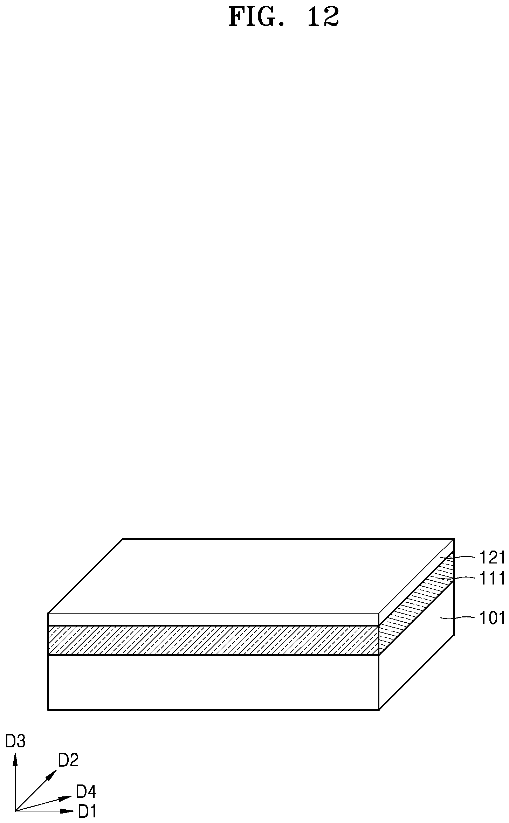

Technical characteristics of each of the first to eighth operations S110 to S180 will be described below in detail with reference to FIGS. 12 to 30.

FIGS. 12 to 30 are diagrams illustrating a process sequence of a method of forming a pattern, according to an embodiment.

Referring to FIG. 12, a first hardmask 111 may be formed on the substrate 101, and a first guide layer 121 may be formed on the first hardmask 111. The first hardmask 111 and first guide layer 121 may form a first stacked structure on the substrate 101. Although not illustrated, the first stacked structure may include a separate etch target layer between the substrate 101 and the first hardmask 111.

Although not shown, an etch target layer may first be formed on the substrate 101 if desired. The etch target layer may be an insulating layer, a conductive layer, or a semiconductor layer that is etched into a final target pattern.

The first hardmask 111 may include a carbon-based material. The first hardmask 111 may be a SOH including an ACL, a hydrocarbon compound, or a derivative thereof.

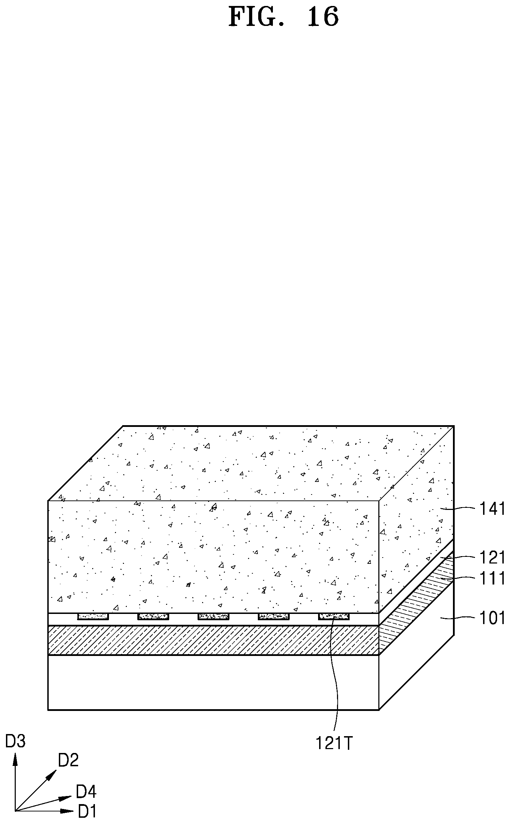

The first guide layer 121 may improve the wettability and bonding properties of the first block copolymer layer 141 (see FIG. 16) in a subsequent process, and may be partially surface-modified. The first guide layer 121 may be formed to be about 10 nm or less, but is not limited thereto.

The first guide layer 121 may include, for example, a cross-linked polymer, a random block copolymer, a homopolymer, etc., but is not limited thereto.

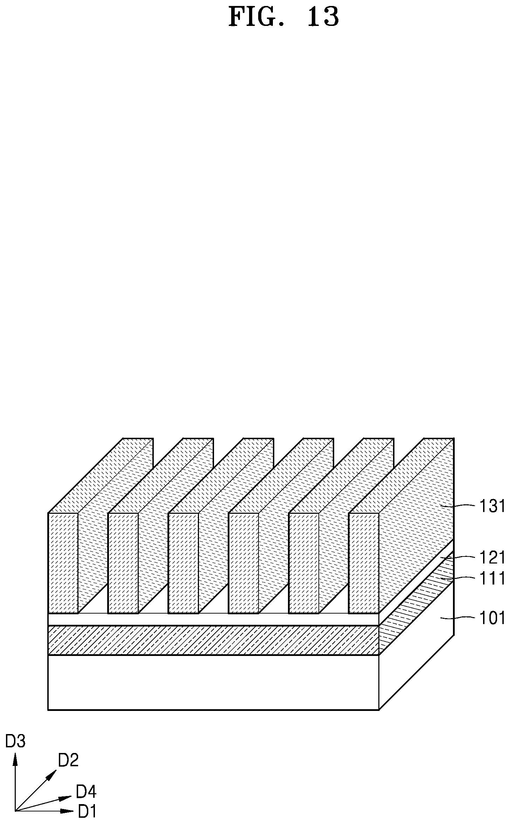

Referring to FIG. 13, after forming an EUV photoresist (not shown) on the first guide layer 121, the EUV photoresist may be exposed and developed in a certain pattern shape to form the first photoresist pattern 131.

The first photoresist pattern 131 may have a plurality of first lines and a plurality of first openings. An upper surface of the first guide layer 121 may be exposed through the plurality of first openings. The first photoresist pattern 131 may be in the shape of lines that are spaced apart from each other in the first direction D1 and extend lengthwise in the second direction D2, but is not limited thereto. For example, the first photoresist pattern 131 may have, in a plan view, the shape of a straight line, a curve, or a linear line having at least two bending points.

The first photoresist pattern 131 may be formed to have a width that may be implemented within the resolution limit of an EUV photolithography process. The first photoresist pattern 131 may include a chemically amplified resist, a chain-scission resist, a cross-linking resist, etc., but is not limited thereto.

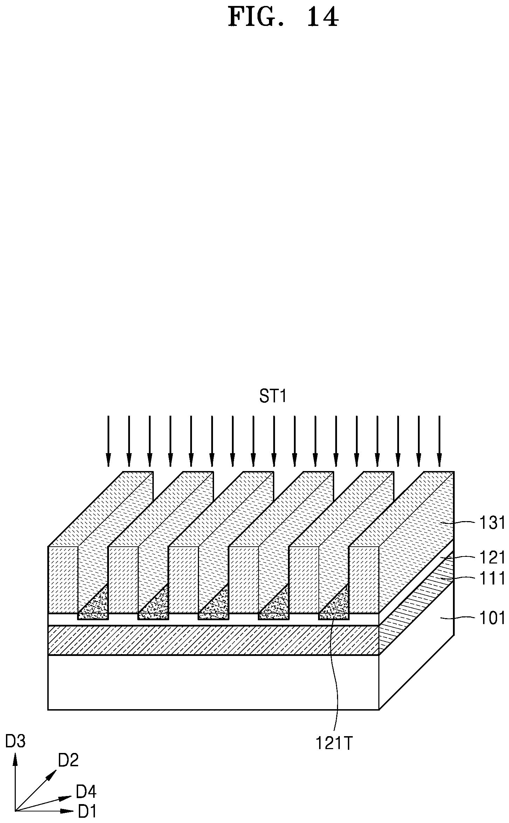

Referring to FIG. 14, a first surface treatment ST1 may be performed on the first guide layer 121 exposed through the plurality of first openings of the first photoresist pattern 131.

The first surface treatment ST1 may be a hydrophilization process of the first guide layer 121 through partial surface modification, partial surface etching, or partial surface plasma treatment. Accordingly, a first surface treatment region 121T may be formed on a surface of the first guide layer 121.

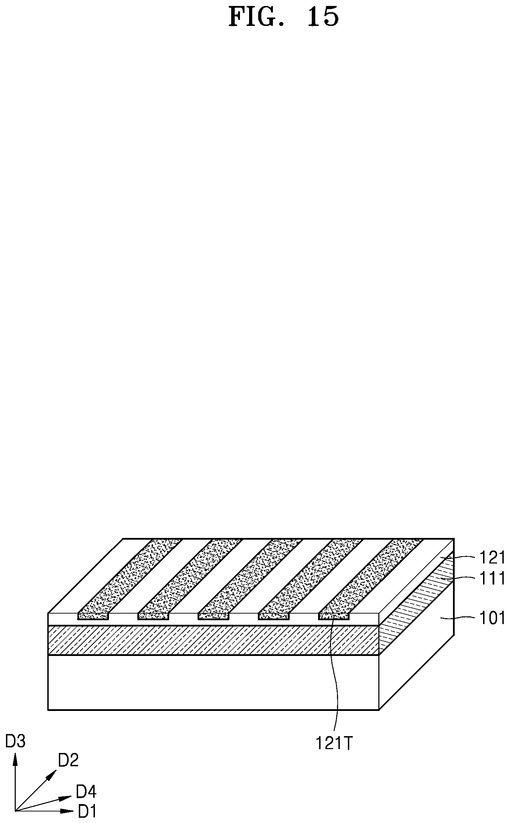

Referring to FIG. 15, the first photoresist pattern 131 may be removed from the first guide layer 121.

The first photoresist pattern 131 may be completely removed by an ashing and stripping process. Accordingly, the whole surface of the first guide layer 121 including the first surface treatment region 121T may be exposed.

Referring to FIG. 16, the first block copolymer layer 141 may be formed on the first guide layer 121 to cover the whole surface of the first guide layer 121 including the first surface treatment region 121T.

In some embodiments, the first block copolymer layer 141 may include a block copolymer in which a first polymer block and a second polymer block are covalently bonded to each other at a volume ratio of 1:1. In other embodiments, the first block copolymer layer 141 may include a bilayer (AB) copolymer including two different types of block copolymers (A and B), a trilayer (ABA) copolymer including two different types of block copolymers (A and B), a trilayer (ABC) copolymer including three different types of block copolymers (A, B, and C), or a multilayer copolymer.

For example, the first block copolymer layer 141 may include a material capable of self-assembly, such as polystyrene-block-polymethylmethacrylate (PS-b-PMMA), polystyrene-block-polyethyleneoxide (PS-b-PEO), polystyrene-block-polydimethylsiloxane (PS-b-PDMS), etc., but is not limited thereto.

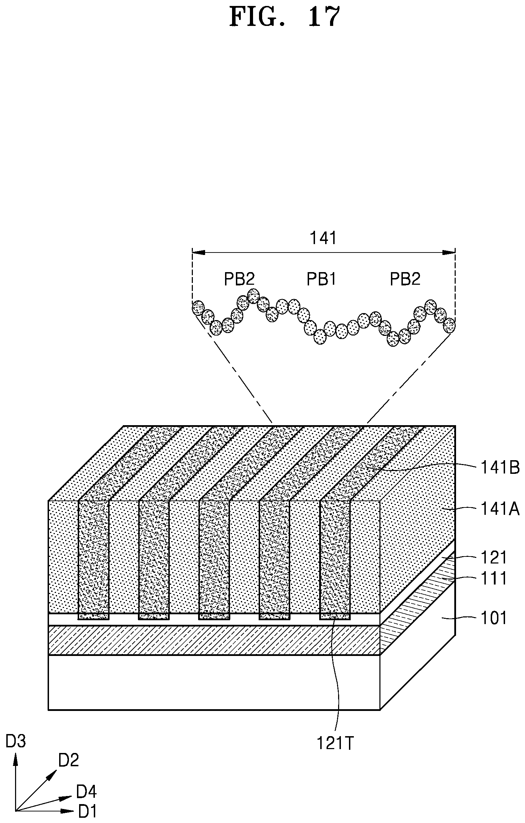

Referring to FIG. 17, through phase separation of the first block copolymer layer 141, the components of the first block copolymer layer 141 may be rearranged so that a self-assembly structure in which a plurality of first polymer blocks PB1 and a plurality of second polymer blocks PB2 having repeating units of different components are alternately and repeatedly arranged may be formed.

The first block copolymer layer 141 may be annealed at a temperature higher than a glass transition temperature of the first block copolymer layer 141. For example, to phase-separate the first block copolymer layer 141, the first block copolymer layer 141 may be annealed at a temperature selected within a range of about 100 °C to about 280 °C for about 2 minutes to about 24 hours.

In some embodiments, the plurality of first polymer blocks PB1 and the plurality of second polymer blocks PB2 may have different polarities depending on the structure of repeating units of polymers constituting the plurality of first polymer blocks PB1 and the plurality of second polymer blocks PB2. For example, the first surface treatment region 121T may have a high affinity for the second polymer block PB2 having a hydrophilic group, and the remaining region of the first guide layer 121 may not have selectivity for either the second polymer block PB2 having a hydrophilic group or the first polymer block PB1 having a hydrophobic group.

Accordingly, the first block copolymer layer 141 may be separated into the first block pattern 141A including the plurality of first polymer blocks PB1 and a sub-block pattern 141B including the plurality of second polymer blocks PB2.

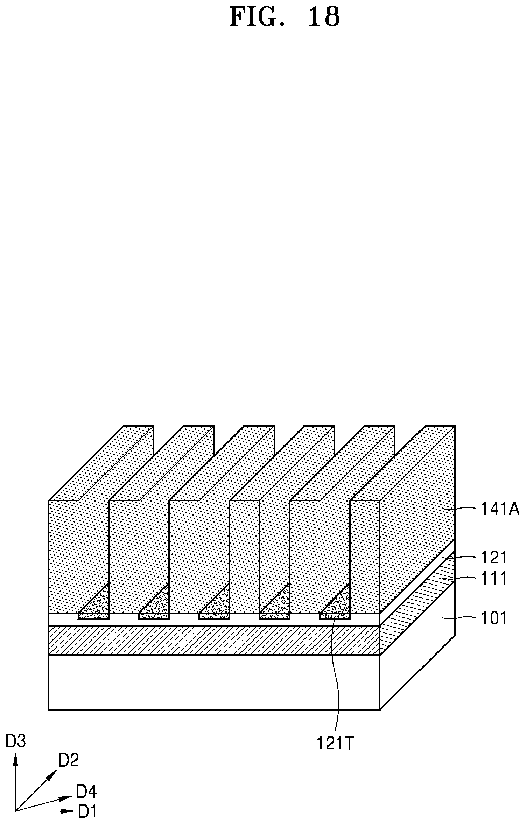

Referring to FIG. 18, from among the first block pattern 141A and the sub-block pattern 141B, the sub-block pattern 141B including the plurality of second polymer blocks PB2 may be selectively removed, leaving behind the first block pattern 141A on the first guide layer 121.

The drawing shows an example in which the sub-block pattern 141B is removed, leaving behind the first block pattern 141A. However, embodiments are not limited thereto, and the first block pattern 141A may be removed, leaving behind the sub-block pattern 141B. To remove the sub-block pattern 141B, for example, a process of irradiating a block to be removed with UV light, or exposing the block to oxygen plasma to photolyze the block and then stripping the photolyzed portion of the block with a cleaning solution may be used.

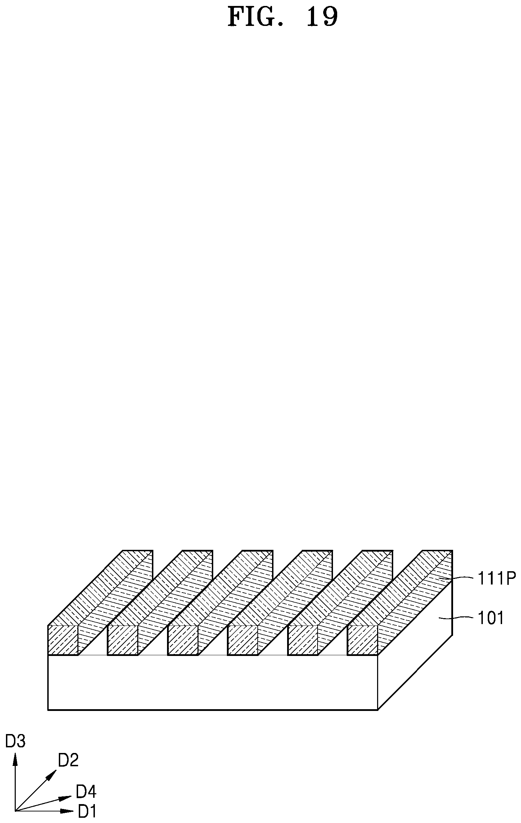

Referring to FIG. 19, the first hardmask pattern 111P may be formed by etching the exposed portion of the first guide layer 121 and the first hardmask 111 therebelow by using the first block pattern 141A as an etch mask.

The first hardmask pattern 111P may have a plurality of first line-and-space patterns, and the first lines may extend lengthwise in the second direction D2. Accordingly, a portion of the upper surface of the substrate 101 may be exposed. That is, the first hardmask pattern 111P may have a structure in which a plurality of first lines and a plurality of openings are alternately repeated.

The first block pattern 141A may be removed, and the first guide layer 121 remaining on the first hardmask pattern 111P may be removed.

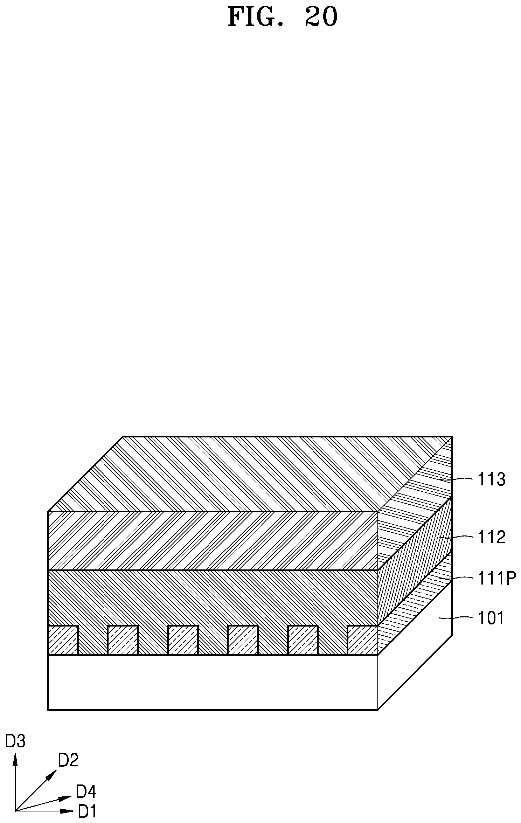

Referring to FIG. 20, second and third hardmasks 112 and 113 may be sequentially formed on the first hardmask pattern 111P.

The second hardmask 112 may include a material having an etch selectivity with respect to the first hardmask pattern 111P. The second hardmask 112 may fill the plurality of openings of the first hardmask pattern 111P and cover the plurality of first lines of the first hardmask pattern 111P, and an upper surface of the second hardmask 112 may be formed to be a flat surface. For example, a composition of the second hardmask 112 may be prepared in a solution form and applied on the first hardmask pattern 111P by spin-on coating.

Also, the third hardmask 113 may include a material having an etch selectivity with respect to the second hardmask 112. The third hardmask 113 may cover the second hardmask 112, and an upper surface of the third hardmask 113 may be formed to be a flat surface.

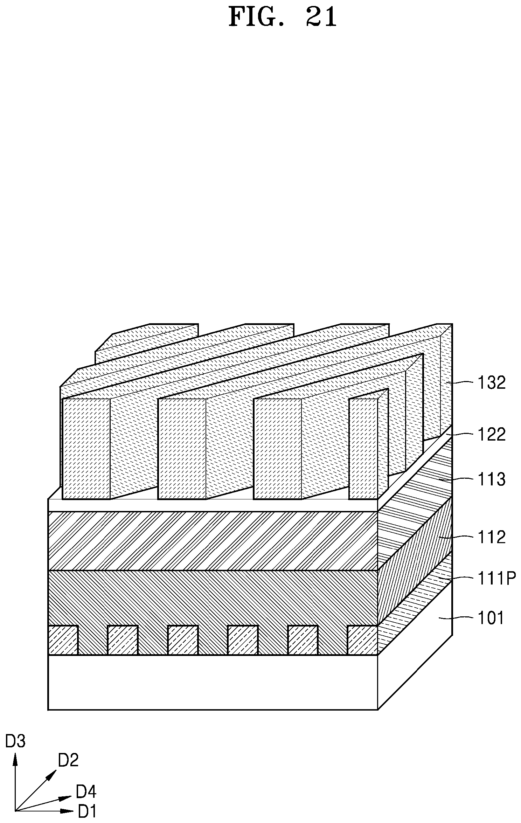

Referring to FIG. 21, a second guide layer 122 may be formed on the upper surface of the third hardmask 113, which is a flat surface.

The second guide layer 122 may be formed to include substantially the same material as the first guide layer 121 and have substantially the same thickness as the first guide layer 121, but is not limited thereto. The second hardmask 112, third hardmask 113, and second guide layer 122 may form a second stacked structure on the substrate 101.

Afterwards, after forming an EUV photoresist (not shown) on the second guide layer 122, the EUV photoresist may be exposed and developed in a certain pattern shape to form a second photoresist pattern 132.

The second photoresist pattern 132 may have a plurality of second lines and a plurality of second openings. An upper surface of the second guide layer 122 may be exposed through the plurality of second openings. The second photoresist pattern 132 may be formed at a certain angle with respect to the first photoresist pattern 131. That is, the second photoresist pattern 132 may be in the shape of a line extending lengthwise in the fourth direction D4, but is not limited thereto. For example, the second photoresist pattern 132 may have, in a plan view, the shape of a straight line, a curve, or a linear line having at least two bending points. The second photoresist pattern 132 may be formed to have a width that may be implemented within the resolution limit of an EUV photolithography process.

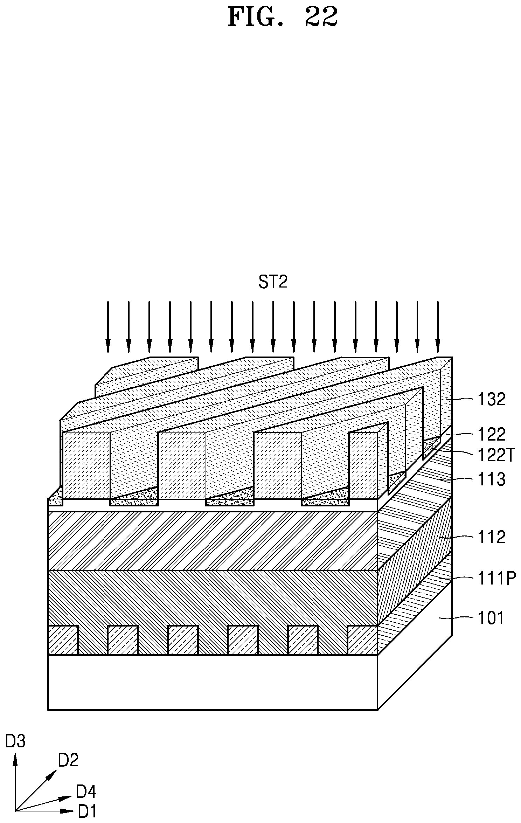

Referring to FIG. 22, a second surface treatment ST2 may be performed on the second guide layer 122 exposed through the plurality of second openings of the second photoresist pattern 132.

The second surface treatment ST2 may be a hydrophilization process of the second guide layer 122 through partial surface modification, partial surface etching, or partial surface plasma treatment. Accordingly, a second surface treatment region 122T may be formed on a surface of the second guide layer 122.

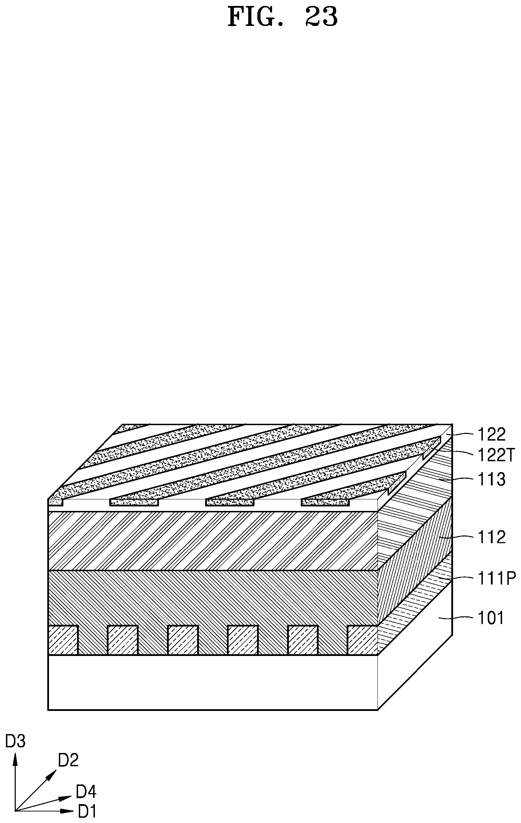

Referring to FIG. 23, the second photoresist pattern 132 may be removed from the second guide layer 122.

The second photoresist pattern 132 may be completely removed by an ashing and stripping process. Accordingly, the whole surface of the second guide layer 122 including the second surface treatment region 122T may be exposed.

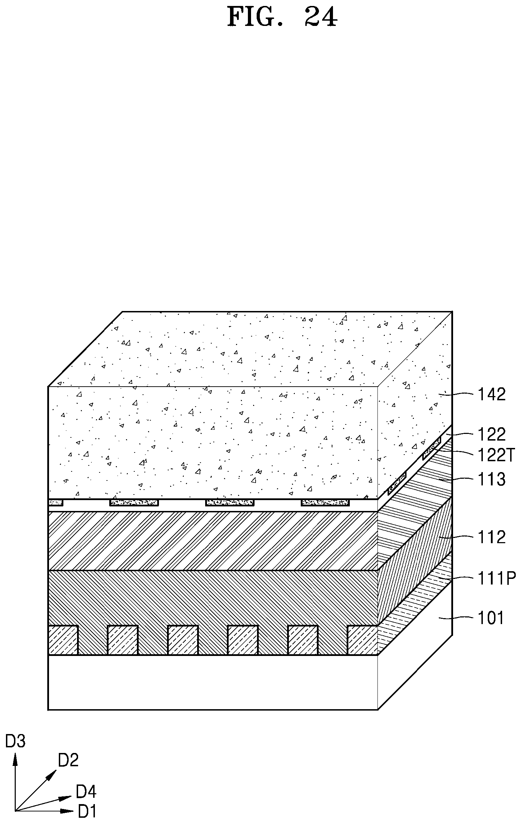

Referring to FIG. 24, the second block copolymer layer 142 may be formed on the second guide layer 122 to cover the whole surface of the second guide layer 122 including the second surface treatment region 122T.

In some embodiments, the second block copolymer layer 142 may include the same material as the first block copolymer layer 141. In other embodiments, the second block copolymer layer 142 may include a different material from the first block copolymer layer 141. Here, an example in which the first block copolymer layer 141 and the second block copolymer layer 142 include the same material is described.

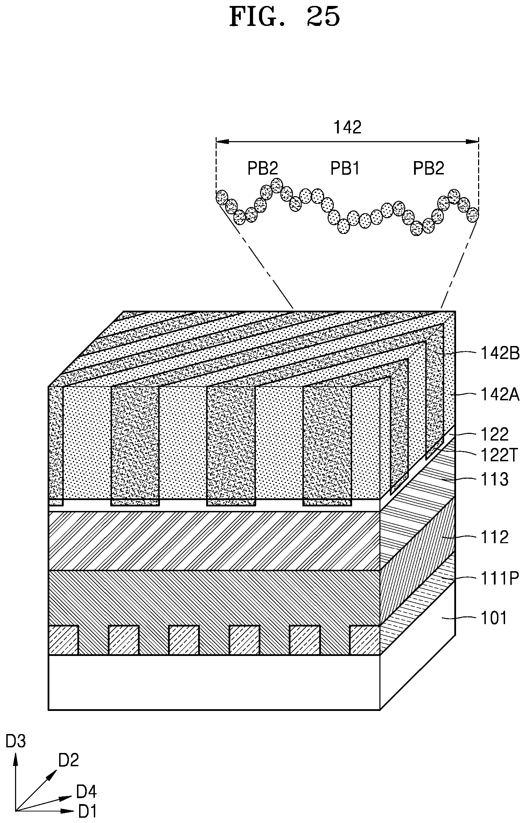

Referring to FIG. 25, through phase separation of the second block copolymer layer 142, the components of the second block copolymer layer 142 may be rearranged so that a self-assembly structure in which a plurality of first polymer blocks PB1 and a plurality of second polymer blocks PB2 having repeating units of different components are alternately and repeatedly arranged may be formed.

The second block copolymer layer 142 may be annealed at a temperature higher than a glass transition temperature of the second block copolymer layer 142.

Accordingly, the second block copolymer layer 142 may be separated into the second block pattern 142A including the plurality of first polymer blocks PB1 and a sub-block pattern 142B including the plurality of second polymer blocks PB2.

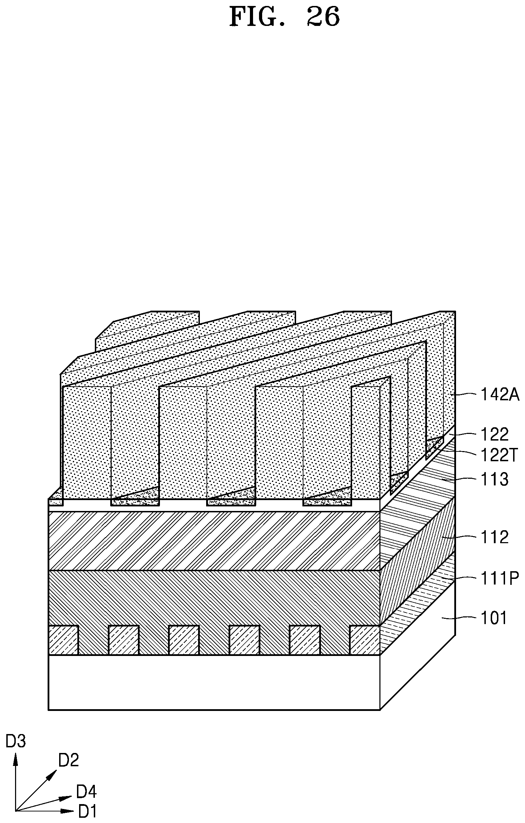

Referring to FIG. 26, from among the second block pattern 142A and the sub-block pattern 142B, the sub-block pattern 142B including the plurality of second polymer blocks PB2 may be selectively removed, leaving behind the second block pattern 142A on the second guide layer 122.

The drawing shows an example in which the sub-block pattern 142B is removed, leaving behind the second block pattern 142A. However, embodiments are not limited thereto, and the second block pattern 142A may be removed, leaving behind the sub-block pattern 142B.

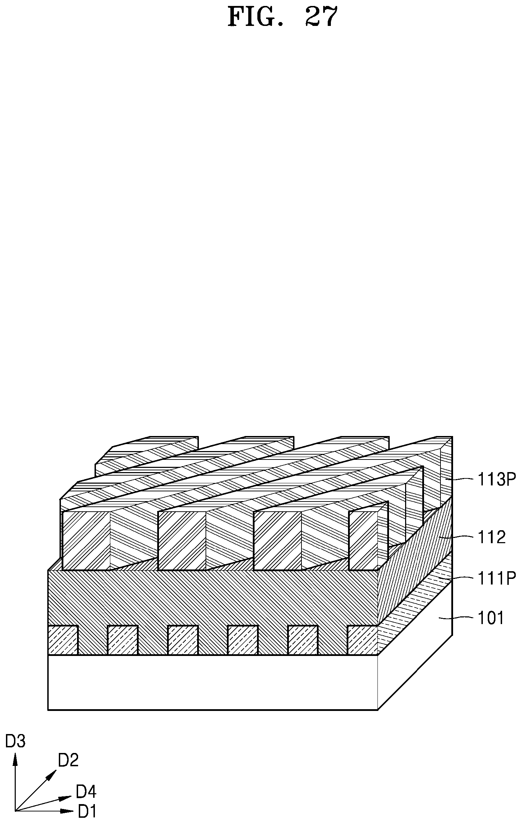

Referring to FIG. 27, a third hardmask pattern 113P may be formed by etching the exposed portion of the second guide layer 122 and the third hardmask 113 therebelow by using the second block pattern 142A as an etch mask.

The third hardmask pattern 113P may have a plurality of third line-and-space patterns, and the third lines may extend lengthwise in the fourth direction D4. Accordingly, a portion of the upper surface of the second hardmask 112 may be exposed. That is, the third hardmask pattern 113P may have a structure in which a plurality of third lines and a plurality of openings are alternately repeated.

The second block pattern 142A may be removed, and the second guide layer 122 remaining on the third hardmask pattern 113P may be removed.

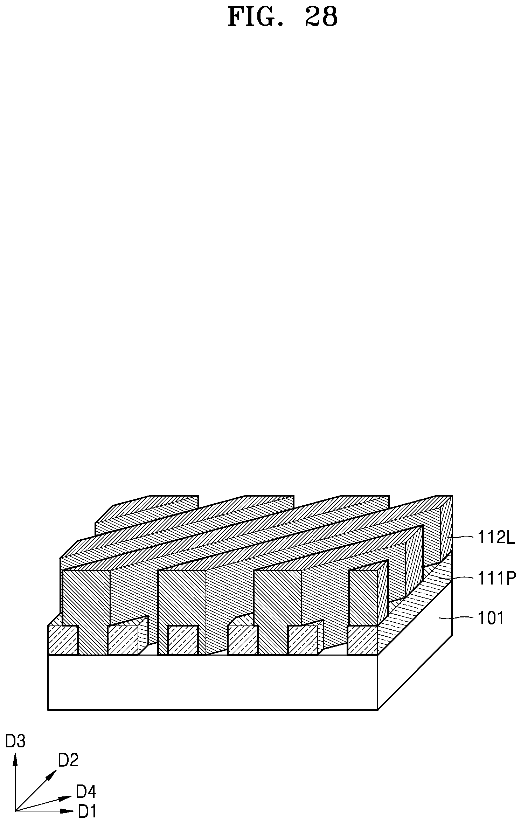

Referring to FIG. 28, a second hardmask line 112L may be formed by etching the exposed portion of the second hardmask 112 by using the third hardmask pattern 113P as an etch mask.

The second hardmask line 112L may have a plurality of second line-and-space patterns, and the second lines may extend lengthwise in the fourth direction D4. Accordingly, a portion of an upper surface of the first hardmask pattern 111P and a portion of the upper surface of the substrate 101 may be exposed. That is, the second hardmask line 112L may have a structure in which a plurality of second lines and a plurality of openings are alternately repeated.

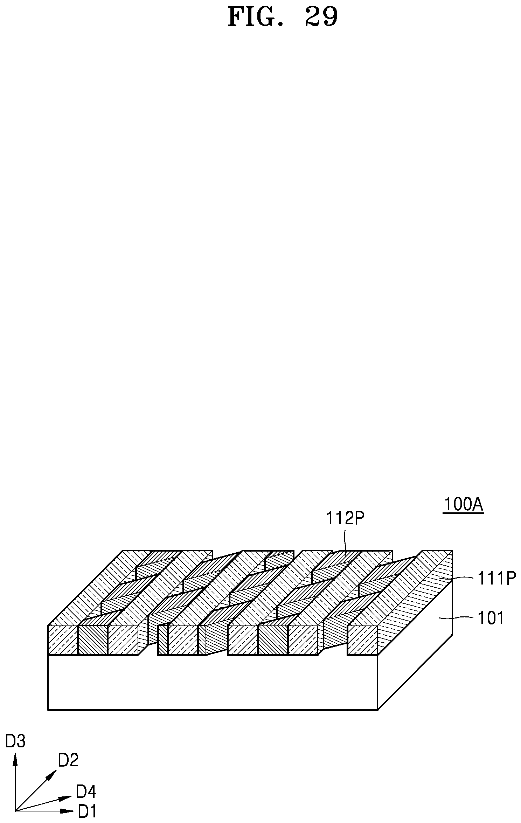

Referring to FIG. 29, the second hardmask pattern 112P may be formed by removing an upper portion of the second hardmask line 112L.

The upper portion of the second hardmask line 112L may be removed so that an upper surface of the second hardmask pattern 112P and the upper surface of the first hardmask pattern 111P have the same vertical level. Accordingly, the pattern structure 100A of the present embodiment may be formed.

In some cases, a process of removing the upper portion of the second hardmask line 112L may be omitted. In some cases, the upper surface of the second hardmask pattern 112P and the upper surface of the first hardmask pattern 111P may have different vertical levels.

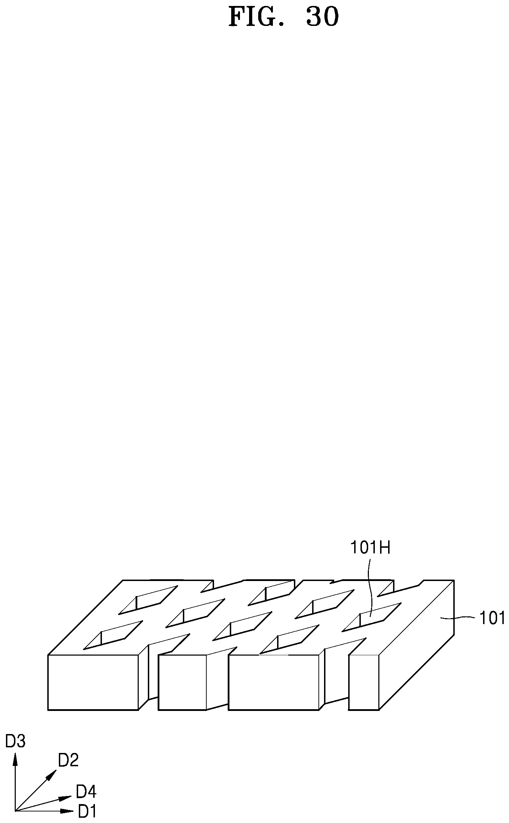

Referring to FIG. 30, a plurality of fine hole patterns 101H may be formed on the substrate 101 by etching the exposed portion of the substrate 101 by using the first hardmask pattern 111P and the second hardmask pattern 112P as etch masks.

The plurality of fine hole patterns 101H may be spaced apart from each other at equal intervals, and may each have the same shape. For example, the plurality of fine hole patterns 101H may each have a parallelogram shape, but are not limited thereto.

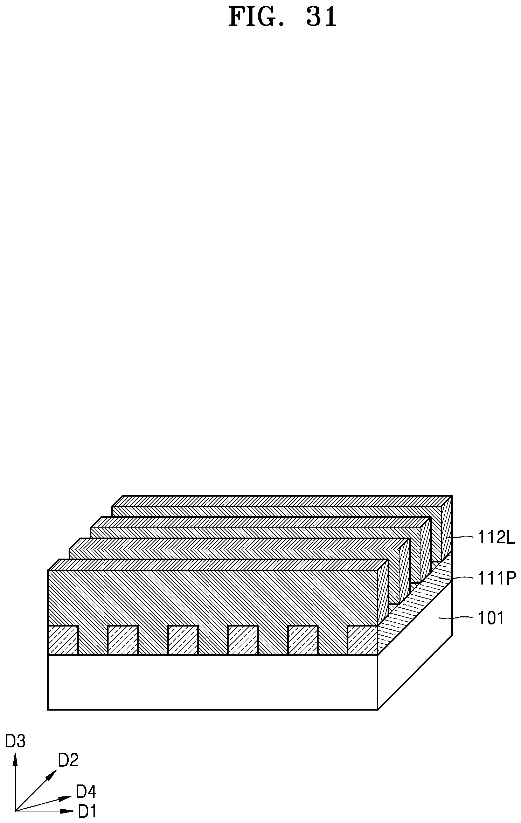

FIGS. 31 to 36 are diagrams illustrating a partial process sequence of a method of forming a pattern, according to another embodiment.

Most of operations included in the method of forming a pattern, according to another embodiment described below, are identical or similar to those described above with reference to FIGS. 12 to 30. Accordingly, for convenience of description, the differences from the method of forming a pattern, according to the embodiment described above, will be mainly described.

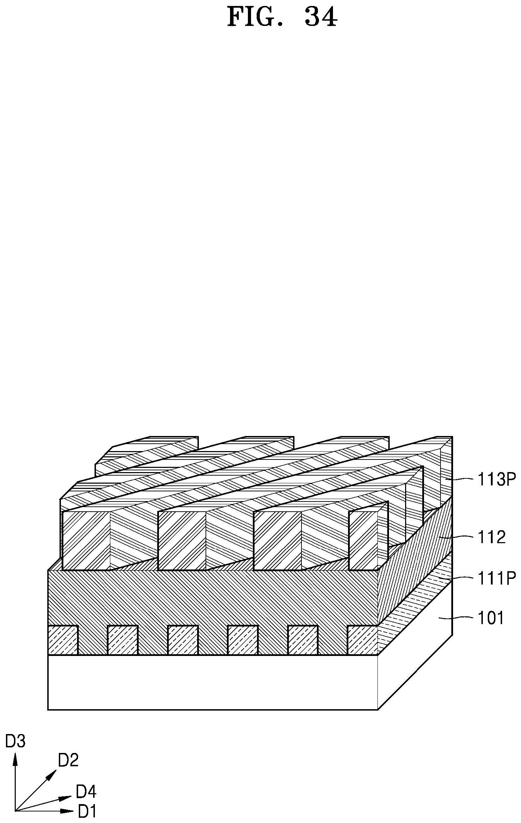

FIGS. 31 to 33 may show a method of forming a pattern, according to another embodiment, and FIGS. 34 to 36 may show a method of forming a pattern according to still another embodiment.

Referring to FIG. 31, the second hardmask line 112L may be formed by etching the exposed portion of the second hardmask 112 by using the third hardmask pattern 113P as an etch mask.

The second hardmask line 112L may have a plurality of second line-and-space patterns, and the second lines may extend lengthwise in the first direction D1. Accordingly, a portion of the upper surface of the first hardmask pattern 111P and a portion of the upper surface of the substrate 101 may be exposed. That is, the second hardmask line 112L may have a structure in which a plurality of second lines and a plurality of openings are alternately repeated.

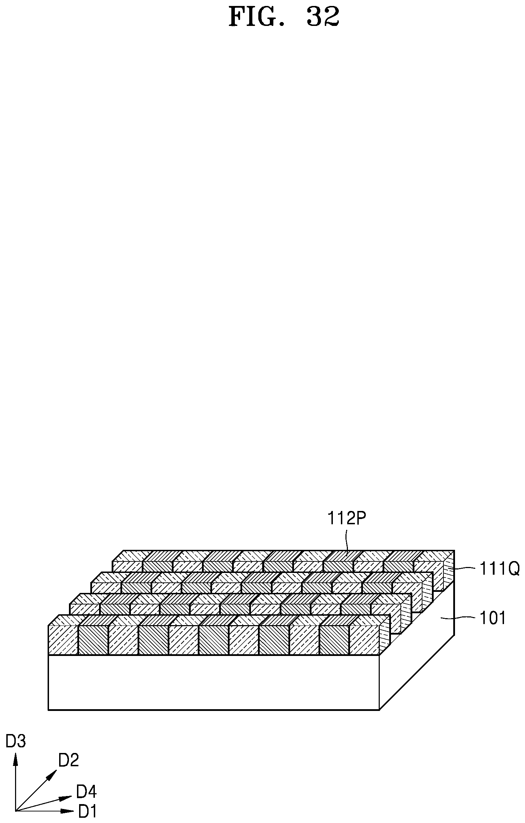

Referring to FIG. 32, the second hardmask pattern 112P and a first hardmask cutting pattern 111Q may be formed by removing the upper portion of the second hardmask line 112L and removing the exposed portion of the first hardmask pattern 111P.

The upper portion of the second hardmask line 112L may be removed so that the upper surface of the second hardmask pattern 112P and an upper surface of the first hardmask cutting pattern 111Q have the same vertical level. In addition, the first hardmask cutting pattern 111Q may be formed in an island shape by removing the exposed portion of the first hardmask pattern 111P.

In some cases, a process of removing the upper portion of the second hardmask line 112L may be omitted. In some cases, the upper surface of the second hardmask pattern 112P and the upper surface of the first hardmask cutting pattern 111Q may have different vertical levels.

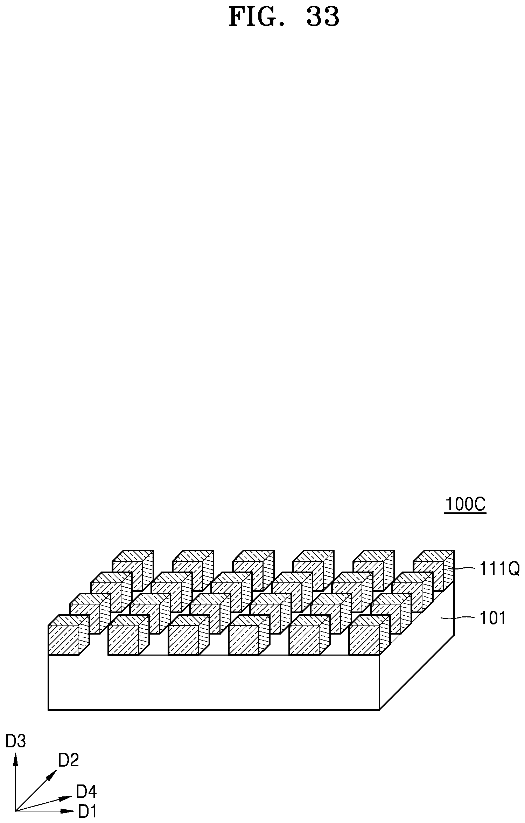

Referring to FIG. 33, the second hardmask pattern 112P may be selectively removed, leaving behind the first hardmask cutting pattern 111Q on the substrate 101.

The first hardmask cutting pattern 111Q may have a plurality of island shapes, and the island shapes may be cuboid shapes. Accordingly, a portion of the upper surface of the substrate 101 may be exposed. By the above method of forming a pattern, a pattern structure 100C may be formed.

Referring to FIG. 34, the third hardmask pattern 113P may be formed.

The third hardmask pattern 113P may have a plurality of third line-and-space patterns, and the third lines may extend lengthwise in the fourth direction D4. Accordingly, a portion of the upper surface of the second hardmask 112 may be exposed. That is, the third hardmask pattern 113P may have a structure in which a plurality of third lines and a plurality of openings are alternately repeated.

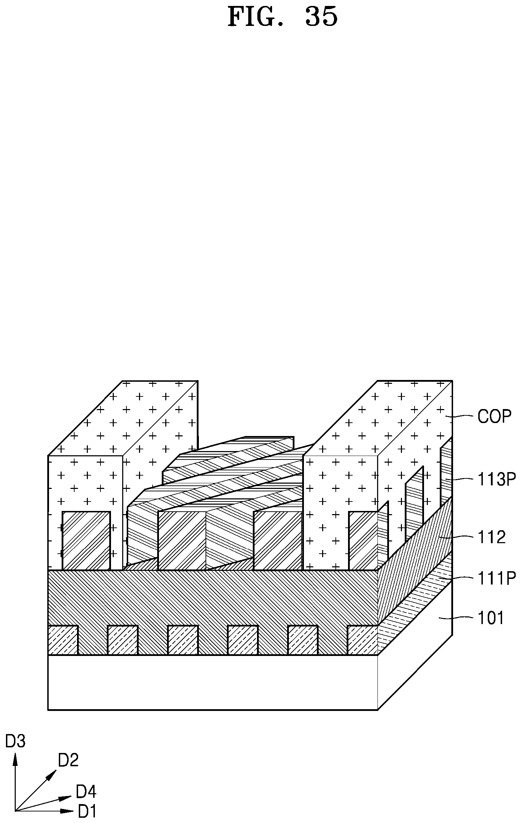

Referring to FIG. 35, a cell open mask COP that exposes a portion of the third hardmask pattern 113P and covers the remaining portion thereof may be formed.

The cell open mask COP may be formed by using an i-line exposure material, a krypton fluoride (KrF) exposure material, or an argon fluoride (ArF) exposure material. That is, the cell open mask COP may include a photoresist material that may be used not in an EUV exposure apparatus, but in a photolithography apparatus having a lower resolution than an EUV exposure apparatus.

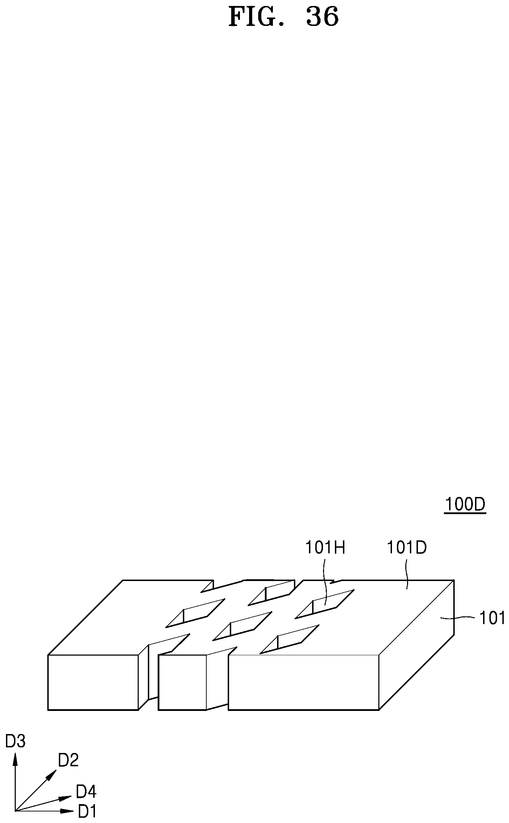

Referring to FIG. 36, a plurality of fine hole patterns 101H may be formed on the substrate 101 by etching the exposed portion of the substrate 101 by using the first hardmask pattern 111P, the third hardmask pattern 113P, and the cell open mask COP as etch masks.

The plurality of fine hole patterns 101H may be spaced apart from each other at equal intervals, and may each have the same shape. For example, the plurality of fine hole patterns 101H may each have a parallelogram shape. However, due to the cell open mask COP, the plurality of fine hole patterns 101H may not be formed in a dummy region 101D of the substrate 101. By the above method of forming a pattern, a pattern structure 100D may be formed.

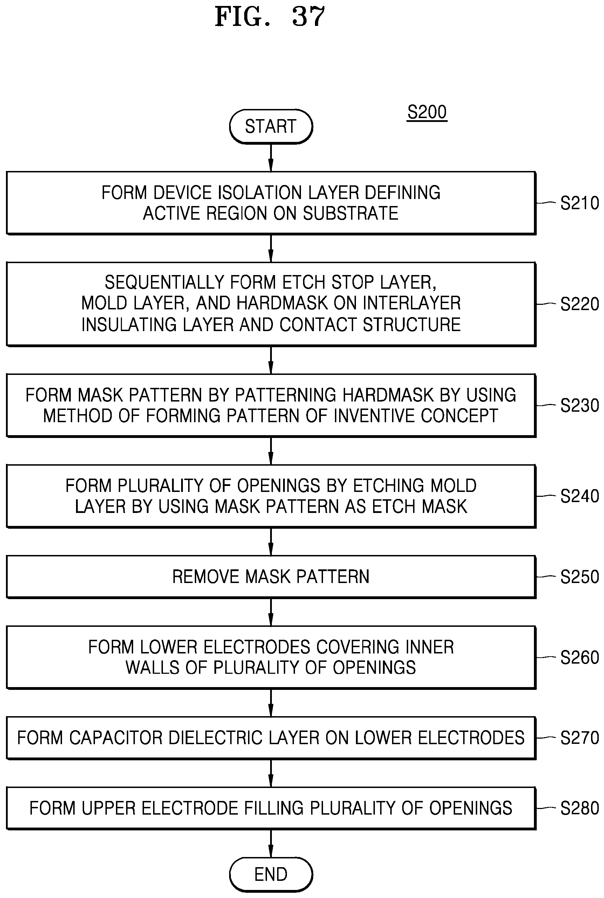

FIG. 37 is a flowchart illustrating a method of manufacturing a semiconductor device, according to an embodiment.

Referring to FIG. 37, a method S200 of manufacturing a semiconductor device may include a process sequence of first to eighth operations S210 to S280.

When an embodiment may be otherwise implemented, a certain process sequence may be performed differently from the described order. For example, two consecutively described processes may be performed substantially at the same time, or may be performed in an order opposite to the described order.

The method S200 of manufacturing a semiconductor device, according to inventive concepts, may include the first operation S210 of forming a device isolation layer defining an active region on a substrate, the second operation S220 of sequentially forming an etch stop layer, a mold layer, and a hardmask on an interlayer insulating layer and a contact structure, the third operation S230 of forming a mask pattern by patterning the hardmask by using the method of forming a pattern of inventive concepts, the fourth operation S240 of forming a plurality of openings by etching the mold layer by using the mask pattern as an etch mask, the fifth operation S250 of removing the mask pattern, the sixth operation S260 of forming lower electrodes covering inner walls of the plurality of openings, the seventh operation S270 of forming a capacitor dielectric layer on the lower electrodes, and the eighth operation S280 of forming an upper electrode filling the plurality of openings.

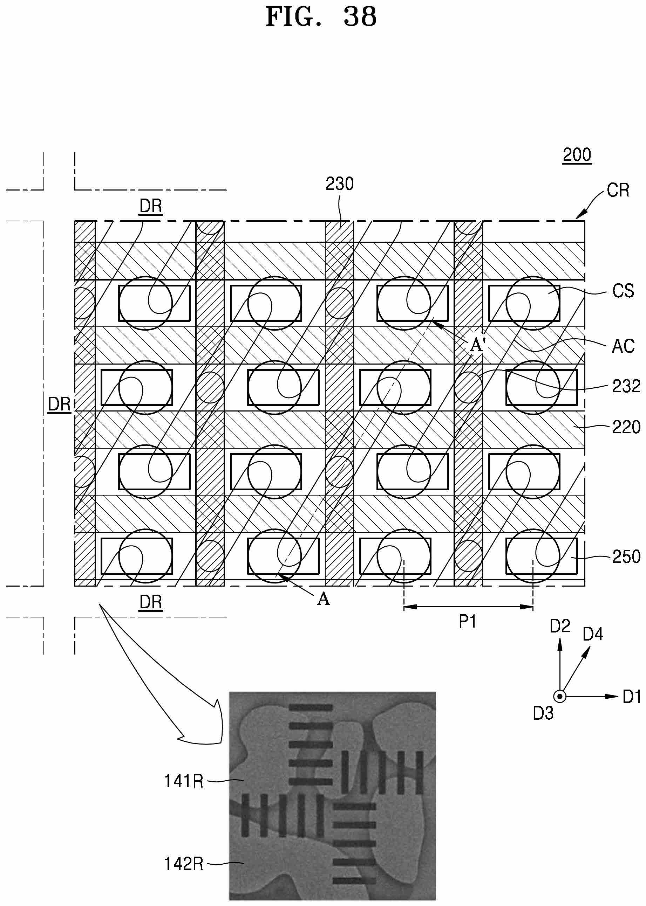

Technical characteristics of each of the first to eighth operations S210 to S280 will be described below in detail with reference to FIGS. 38 to 47.

FIGS. 38 to 47 are diagrams illustrating a process sequence of a method of manufacturing a semiconductor device, according to an embodiment.

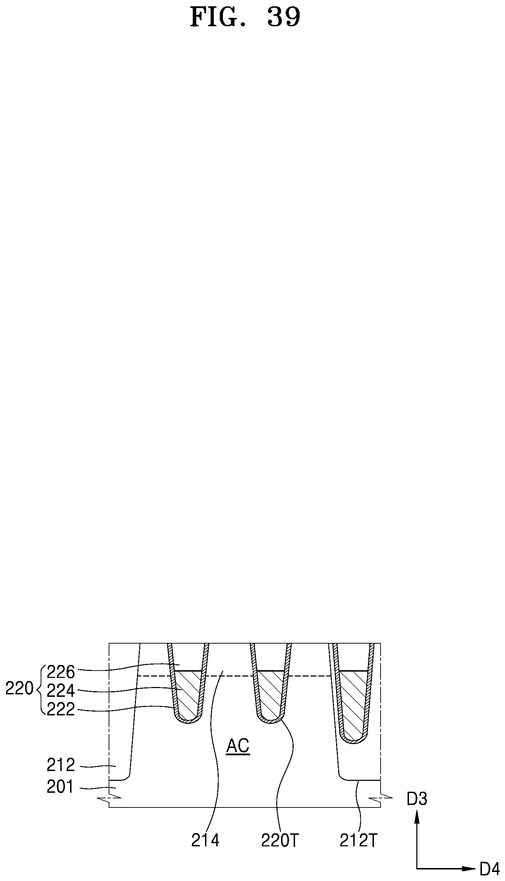

FIGS. 39 to 47 are cross-sectional views taken along line A-A' of FIG. 38.

Referring to FIG. 38, a semiconductor device 200 may include a dummy region DR surrounding a cell region CR.

An active region AC, a gate structure 220, a bit line structure 230, a bit line contact 232, a contact structure 250, and a capacitor structure CS may be arranged in the cell region CR. In the capacitor structure CS, a first pitch P1 between lower electrodes may be in a range of about 12 nm to about 30 nm.

The dummy region DR may be a residual scribe lane region that remains after cutting a substrate. In the dummy region DR, an auxiliary pattern that is required in a manufacturing process of the semiconductor device 200 but does not remain in a final product may be formed, rather than a pattern constituting the semiconductor device 200.

Also, block copolymer layer residues 141R and 142R may remain in the dummy region DR. The block copolymer layer residues 141R and 142R may be a feature resulting from the method of forming a pattern of inventive concepts. In the dummy region DR, the block copolymer layer residues 141R and 142R may be arranged into a plurality of blocks having repeating units of different components through phase separation.

A method of manufacturing the semiconductor device 200 will be described in detail below.

Referring to FIG. 39, a device isolation trench 212T may be formed in a substrate 201, and a device isolation layer 212 defining the active region AC may be formed within the device isolation trench 212T.

A gate line trench 220T may be formed in the substrate 201. The gate line trenches 220T may extend parallel to each other, and may each have a line shape crossing the active region AC.

A gate insulating layer 222 may be formed on an inner wall of the gate line trench 220T. A gate electrode layer 224 may be formed on the gate insulating layer 222. An insulating material may be formed to fill the remaining portion of the gate line trench 220T, and the insulating material may be planarized so that an upper surface of the substrate 201 is exposed, thereby forming a gate capping layer 226 on the inner wall of the gate line trench 220T.

Impurity ions may be injected into the substrate 201 on both sides of the gate structure 220 to form a source/drain region 214.

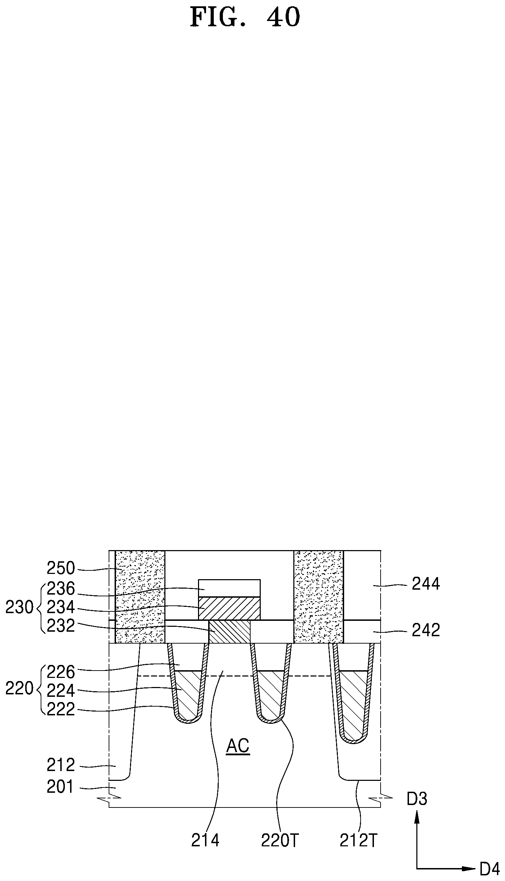

Referring to FIG. 40, a first interlayer insulating layer 242 may be formed on the substrate 201, and an opening exposing an upper surface of the source/drain region 214 may be formed in the first interlayer insulating layer 242.

A conductive layer filling the opening may be formed on the first interlayer insulating layer 242, and an upper portion of the conductive layer may be planarized to form the bit line contact 232 electrically connected to the source/drain region 214 within the opening.

A conductive layer and an insulating layer may be sequentially formed on the first interlayer insulating layer 242, and the conductive layer and the insulating layer may be patterned to form a bit line 234 and a bit line capping layer 236, which extend in the second direction D2 parallel to an upper surface of the substrate 201. The bit line contact 232, the bit line 234, and the bit line capping layer 236 may be referred to as the bit line structure 230.

A second interlayer insulating layer 244 covering the bit line 234 and the bit line capping layer 236 may be formed on the first interlayer insulating layer 242.

An opening exposing the upper surface of the source/drain region 214 may be formed in each of the first and second interlayer insulating layers 242 and 244, and the contact structure 250 may be formed within the opening.

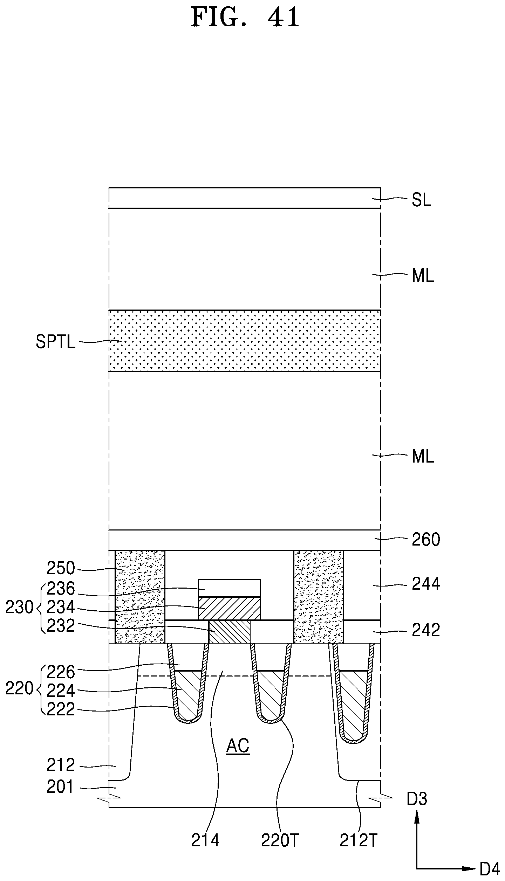

Referring to FIG. 41, an etch stop layer 260, a mold layer ML, a supporter forming layer SPTL, and a sacrificial layer SL may be sequentially formed on the second interlayer insulating layer 244 and the contact structure 250.

The supporter forming layer SPTL may be formed between the mold layers ML. The supporter forming layer SPTL may include an insulating material, for example, silicon oxide, silicon nitride, or silicon oxynitride. Also, the sacrificial layer SL may be formed on the mold layer ML.

Referring to FIG. 42, the mask pattern MP1 of inventive concepts may be formed on the sacrificial layer SL.

The mask pattern MP1 may be formed on the sacrificial layer SL according to the above-described method of forming a pattern of inventive concepts. The mask pattern MP1 may include the first hardmask pattern 111P and the second hardmask pattern 112P. The mask pattern MP1 may include a material having etch resistance, so as to serve as an etch mask during sequential etching of the sacrificial layer SL, the supporter forming layer SPTL, and the mold layer ML.

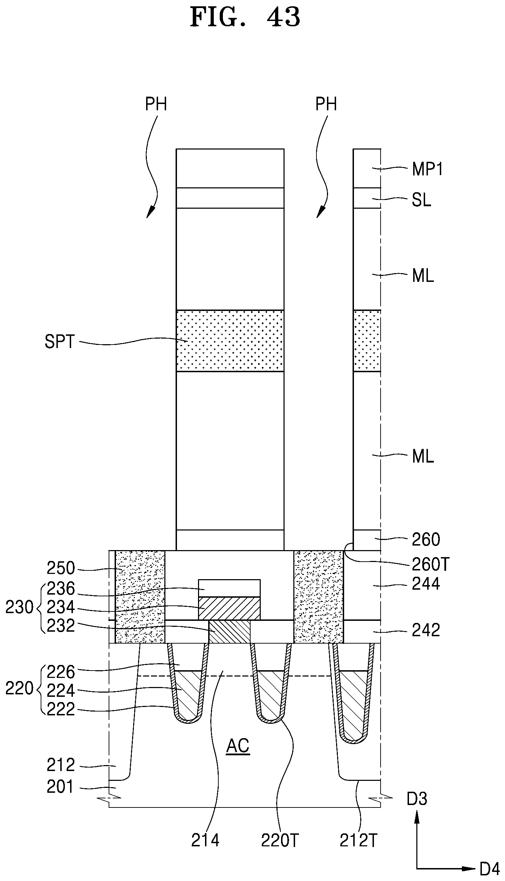

Referring to FIG. 43, a fine hole pattern PH may be formed by sequentially etching the sacrificial layer SL, the supporter forming layer SPTL, and the mold layer ML by using the mask pattern MP1 as an etch mask.

An opening 260T may be formed by removing a portion of the etch stop layer 260 exposed at the bottom of the fine hole pattern PH. An upper surface of the contact structure 250 may be exposed by the fine hole pattern PH and the opening 260T. Afterwards, the mask pattern MP1 may be removed.

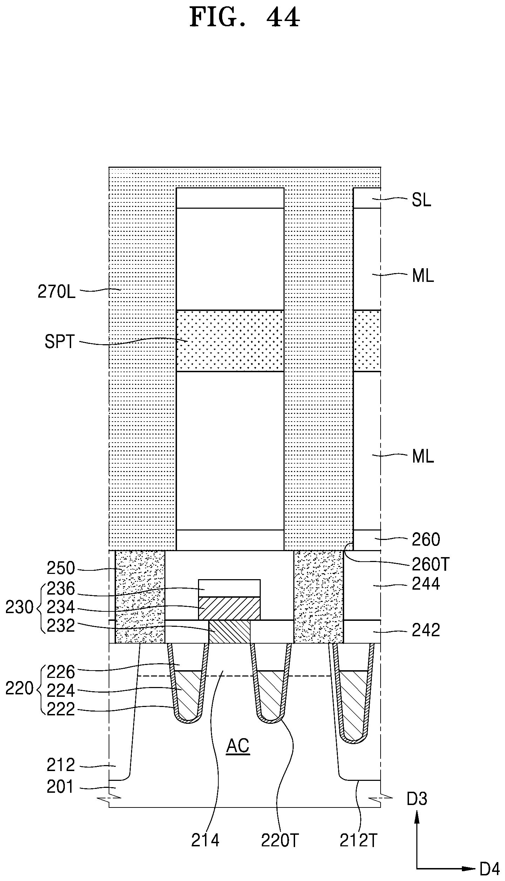

Referring to FIG. 44, a lower electrode forming layer 270L may be formed to conformally cover the fine hole pattern PH and an inner wall of the opening 260T.

In some embodiments, the lower electrode forming layer 270L may be formed on a side surface of the etch stop layer 260, a side surface of the mold layer ML, a side surface of a supporter SPT, and side and upper surfaces of the sacrificial layer SL, so as to be in contact with the upper surface of the contact structure 250.

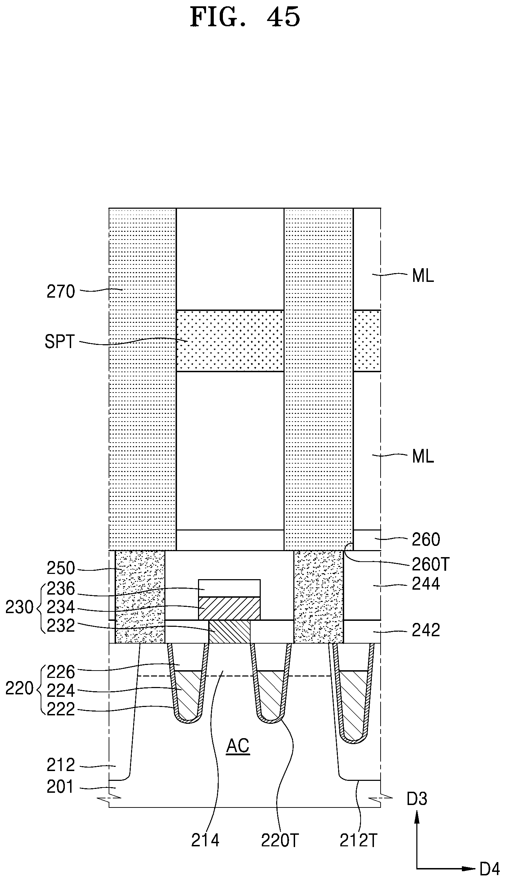

Referring to FIG. 45, lower electrodes 270 may be formed by removing a portion of the lower electrode forming layer 270L and the sacrificial layer SL, which are located on an upper surface of the mold layer ML, through a node separation process.

The node separation process may remove the sacrificial layer SL together with the portion of the lower electrode forming layer 270L by using an etch-back process or a chemical mechanical polishing (CMP) process.

Afterwards, the mold layer ML may be removed. For example, the mold layer ML may include silicon oxide, and in this case, the mold layer ML may be completely removed by a wet etching process using hydrofluoric acid or a buffered oxide etchant (BOE) solution.

Although not shown, depending on the shape of the plurality of openings 110H1 (see FIG. 42) of the mask pattern MP1 (see FIG. 42), each of the lower electrodes 270 may have a parallelogram shape in a plan view, but is not limited thereto.

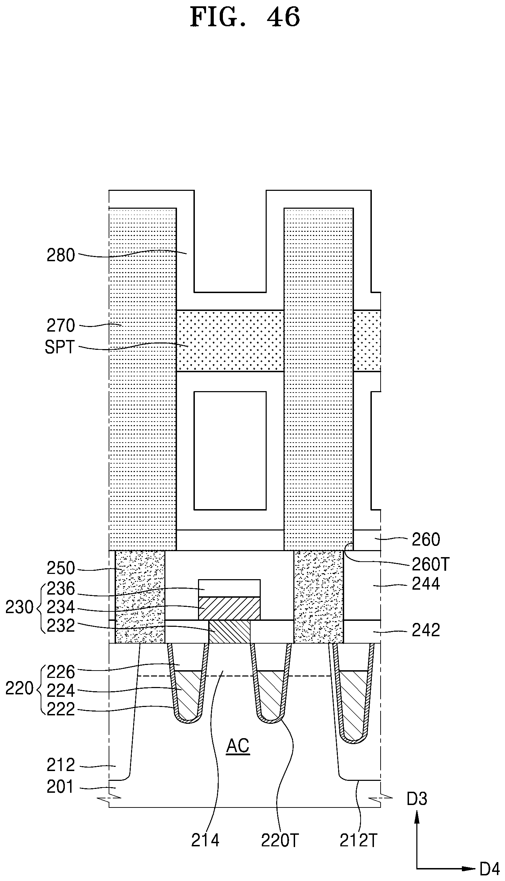

Referring to FIG. 46, a capacitor dielectric layer 280 may be formed on outer surfaces of the lower electrodes 270 and the supporter SPT.

The capacitor dielectric layer 280 may include a high-k dielectric material having a higher dielectric constant than silicon oxide. For example, the capacitor dielectric layer 280 may have a dielectric constant of about 10 to 25.

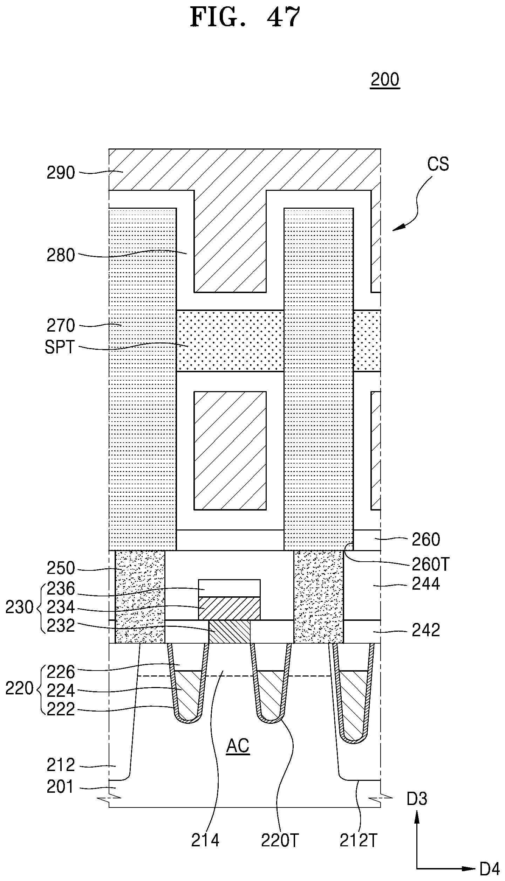

Referring to FIG. 47, an upper electrode 290 may be formed to completely fill a space defined by inner walls of the lower electrodes 270 on the capacitor dielectric layer 280.

In some embodiments, the upper electrode 290 may be formed to be in direct contact with the capacitor dielectric layer 280. The capacitor structure CS may include the lower electrodes 270, the capacitor dielectric layer 280, and the upper electrode 290.

By sequentially performing the above manufacturing processes, the semiconductor device 200 of inventive concepts may be completed.

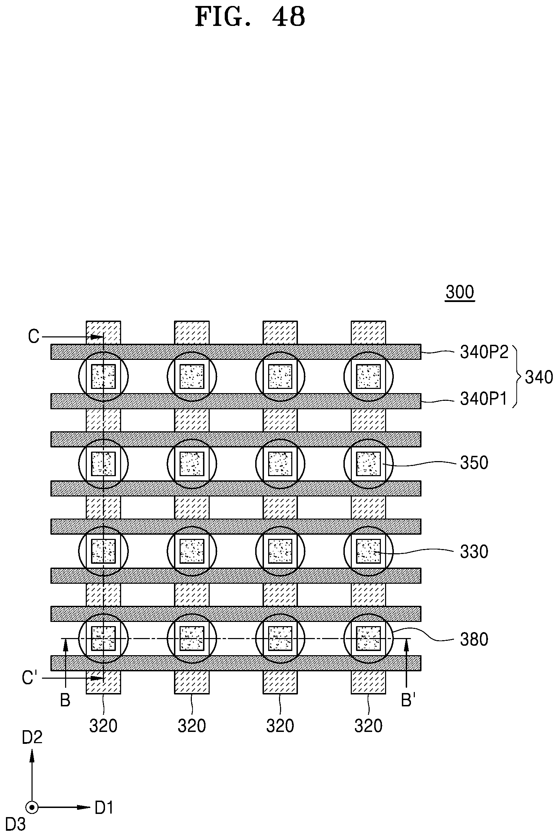

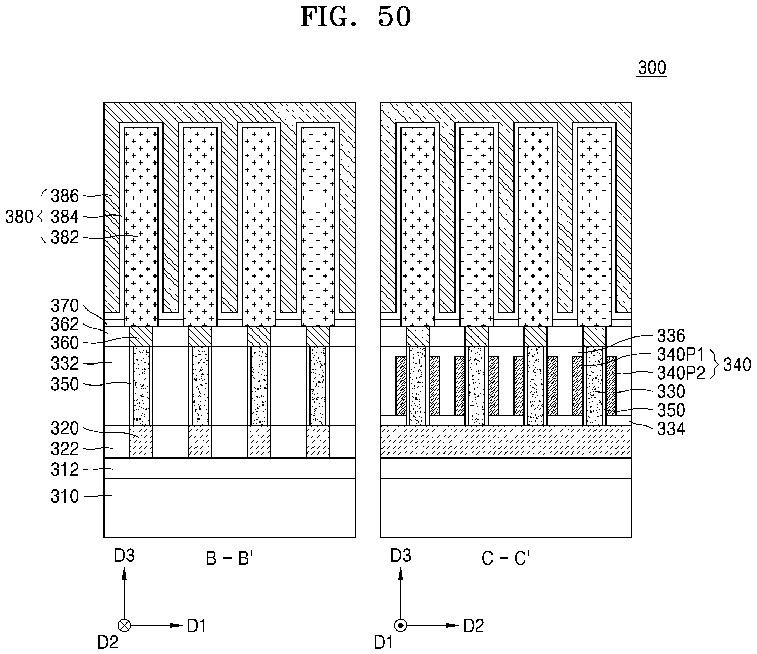

FIGS. 48 to 50 are diagrams illustrating a partial process sequence of a method of manufacturing a semiconductor device, according to another embodiment.

Referring to FIGS. 48 to 50 together, a semiconductor device 300 may include a substrate 310, a plurality of first conductive lines 320, a channel layer 330, a gate electrode 340, a gate insulating layer 350, and a capacitor structure 380.

The semiconductor device 300 may include a vertical channel transistor (VCT). The VCT may refer to a structure in which the channel length of the channel layer 330 extends from the substrate 310 in the third direction D3.

A lower insulating layer 312 may be arranged on the substrate 310, and the plurality of first conductive lines 320 may be spaced apart from each other in the first direction D1 and extend in the second direction D2 on the lower insulating layer 312. A plurality of first insulating patterns 322 may be arranged on the lower insulating layer 312 to fill a space between the plurality of first conductive lines 320. The plurality of first conductive lines 320 may function as bit lines of the semiconductor device 300.

The channel layers 330 may be arranged in a matrix form on the plurality of first conductive lines 320 to be spaced apart from each other in the first direction D1 and the second direction D2. The channel layer 330 may have a first width in the first direction D1 and a first height in the third direction D3, and the first height may be greater than the first width.

The gate electrode 340 may extend in the first direction D1 on both sidewalls of the channel layer 330. The gate electrode 340 may include a first sub-gate electrode 340P1 facing a first sidewall of the channel layer 330, and a second sub-gate electrode 340P2 facing a second sidewall of the channel layer 330, which is opposite to the first sidewall of the channel layer 330.

The gate insulating layer 350 may surround a sidewall of the channel layer 330, and may be arranged between the channel layer 330 and the gate electrode 340. For example, the entire sidewall of the channel layer 330 may be surrounded by the gate insulating layer 350, and a portion of a sidewall of the gate electrode 340 may be in contact with the gate insulating layer 350.

A plurality of second insulating patterns 332 may extend in the second direction D2 on the plurality of first insulating patterns 322, and the channel layer 330 may be arranged between two adjacent ones of the second insulating patterns 332, from among the plurality of second insulating patterns 332. Also, between two adjacent ones of the second insulating patterns 332, a first buried layer 334 and a second buried layer 336 may be arranged in a space between two adjacent ones of the channel layers 330.

Capacitor contacts 360 may be arranged on the channel layers 330. The capacitor contacts 360 may be arranged to vertically overlap the channel layers 330, and may be arranged in a matrix form to be spaced apart from each other in the first direction D1 and the second direction D2. An upper insulating layer 362 may surround a sidewall of the capacitor contact 360 on the plurality of second insulating patterns 332 and the second buried layer 336.

An etch stop layer 370 may be arranged on the upper insulating layer 362, and the capacitor structure 380 may be arranged on the etch stop layer 370. The capacitor structure 380 may include lower electrodes 382, a capacitor dielectric layer 384, and an upper electrode 386.

In a method of manufacturing the semiconductor device 300 of inventive concepts, the mask pattern MP2 may be formed on a lower electrode forming layer 381 according to the above-described method of forming a pattern of inventive concepts. The mask pattern MP2 may include the first hardmask pattern 111P and the second hardmask pattern 112P. The mask pattern MP2 may include a material having etch resistance, so as to serve as an etch mask during etching of the lower electrode forming layer 381.

The lower electrodes 382 may penetrate the etch stop layer 370 and be electrically connected to an upper surface of the capacitor contact 360. Each of the lower electrodes 382 may be formed in a pillar type extending in the third direction D3, but is not limited thereto. In some embodiments, the lower electrodes 382 may be arranged to vertically overlap the capacitor contacts 360, and may be arranged in a matrix form to be spaced apart from each other in the first direction D1 and the second direction D2.

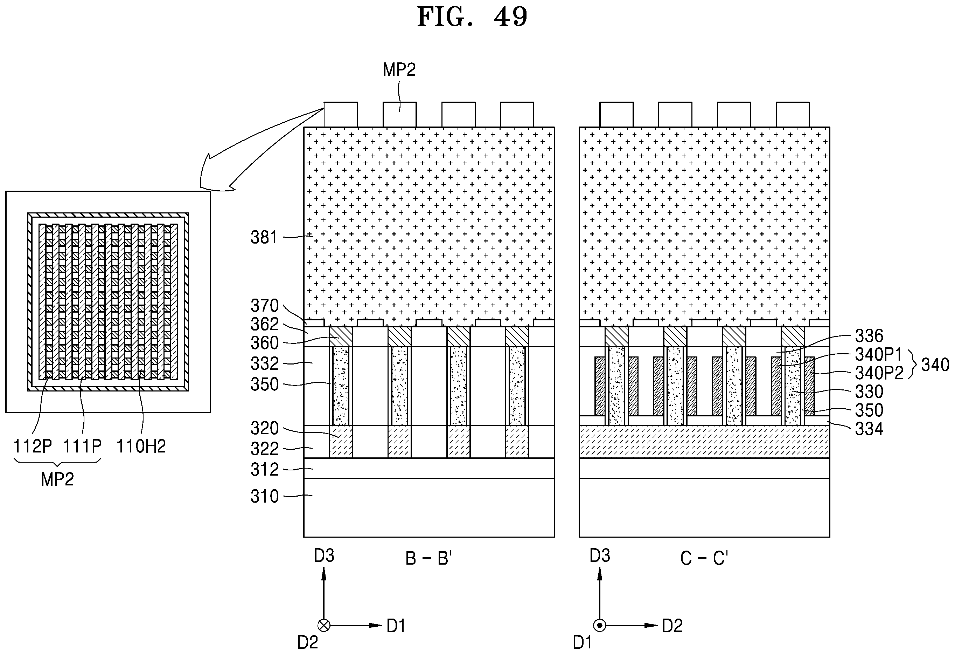

Although not shown, depending on the shape of the plurality of openings 110H2 (see FIG. 49) of the mask pattern MP2 (see FIG. 49), each of the lower electrodes 382 may have a rectangular shape in a plan view, but is not limited thereto.

A semiconductor device according to one or more embodiments includes: a substrate having a cell region, a dummy region surrounding the cell region, and a plurality of active regions arranged in the cell region; a plurality of gate structures arranged on the substrate; a plurality of bit lines arranged on the substrate and connected to the plurality of active regions through a plurality of bit line contacts; and a capacitor structure electrically connected to the plurality of active regions and including lower electrodes, a capacitor dielectric layer, and an upper electrode, wherein a block copolymer residue is present in the dummy region, and a pitch between the lower electrodes in the cell region is in a range of about 12 nm to about 30 nm.

In one or more embodiments, the lower electrodes include a plurality of first lower electrodes arranged in parallel in one direction, and a plurality of second lower electrodes arranged in parallel in another direction forming a certain angle with the one direction.

In one or more embodiments, the certain angle formed by the plurality of first lower electrodes and the plurality of second lower electrodes is greater than 0° and less than 180°.

In one or more embodiments, in the dummy region, the block copolymer residue is formed into a plurality of blocks having repeating units of different components through phase separation.

In one or more embodiments, the block copolymer residue includes at least one selected from polystyrene-block-polymethylmethacrylate (PS-b-PMMA), polystyrene-block-polyethyleneoxide (PS-b-PEO), and polystyrene-block-polydimethylsiloxane (PS-b-PDMS).

In one or more embodiments, the dummy region includes a residual scribe lane region.

In one or more embodiments, the lower electrodes are formed by etching a lower electrode forming layer by using a cross pattern as an etch mask, and the cross pattern is formed by an EUV photolithography process and a phase separation process of a block copolymer.

In one or more embodiments, the cross pattern is formed by at least two EUV photolithography processes and at least two phase separation processes of the block copolymer.

In one or more embodiments, in a plan view, each of the lower electrodes has a parallelogram shape.

In one or more embodiments, in a plan view, each of the lower electrodes has a rectangular shape.

A method of forming a mask pattern according to one or more embodiments may include: forming a first stacked structure on a substrate, the first stacked structure including a first guide layer on a first hardmask, wherein a surface of the first guide layer may include first surface treatment regions and a first remaining region between the first surface treatment regions; forming a first block pattern on the first guide layer by forming a first block copolymer layer on the first guide layer, phase separating the first block copolymer layer into first polymer blocks of the first block copolymer layer and second polymer blocks of the first block copolymer layer so the second polymer blocks of the first block copolymer layer may be formed on the first surface treatment regions of the first guide layer and the first polymer blocks of the first block copolymer layer may be formed on the first remaining region of the first guide layer, and then selectively removing the second polymer blocks of the first block copolymer layer to form the first block pattern; forming a first hardmask pattern by etching through the first hardmask using the first block pattern as an etch mask, the first hardmask pattern having a plurality of first line patterns spaced apart from each other, and removing the first block pattern and the first guide layer; forming a second stacked structure on the first hardmask pattern, the second stacked structure including a second hardmask over the first hardmask pattern and the substrate, a third hardmask on the second hardmask, and a second guide layer on the third hardmask, wherein a surface of the second guide layer may include second surface treatment regions and a second remaining region between the second surface treatment regions; forming a second block pattern on the second guide layer by forming a second block copolymer layer on the second guide layer, phase separating the second block copolymer layer into first polymer blocks of the second block copolymer layer and second polymer blocks of the second block copolymer layer so the second polymer blocks of the second block copolymer layer are formed on the second surface treatment regions of the second guide layer and the first polymer blocks of the second block copolymer layer are formed on the second remaining region of the second guide layer, and then selectively removing the second polymer blocks of the second block copolymer layer to form the first block pattern; forming a third hardmask pattern by etching the third hardmask using the second block pattern as an etch mask, the third hardmask pattern having a plurality of third line patterns spaced apart from each other and crossing the plurality of first line patterns at a certain angle; and forming a second hardmask pattern by a process that includes etching the second hardmask using the third hardmask pattern as an etch mask to form a plurality of second line patterns spaced apart from each other, wherein the mask pattern is defined by the first hardmask pattern and the second hardmask pattern.

In some embodiments, the first hardmask pattern may include a plurality of first space patterns, which may be alternately arranged with the plurality of first line patterns, the second hardmask may fill the plurality of first space patterns of the first hardmask pattern and cover the plurality of first line patterns of the first hardmask pattern, and an upper surface of the second hardmask may be a flat surface.

In some embodiments, the second hardmask pattern may include a plurality of second space patterns, which may be alternately arranged with the plurality of second line patterns, and the certain angle formed by the plurality of first line patterns and the plurality of third line patterns may be greater than 0° and less than 180°.

In some embodiments, after the forming the third hardmask pattern, the method may include forming a cell open mask covering a portion of the third hardmask pattern.

In some embodiments, the first stacked structure may be spaced apart from an upper surface of the substrate. The first surface treatment regions of the first guide layer may have a higher affinity for the second polymer blocks of the first block copolymer layer than the first polymer blocks of the first block copolymer layer. The first surface treatment regions of the second guide layer may have a higher affinity for the second polymer blocks of the second block copolymer layer than the first polymer blocks of the second block copolymer layer.

While inventive concepts have been particularly shown and described with reference to embodiments thereof, it will be understood that various changes in form and details may be made therein without departing from the scope of the following claims.

## Claims

1. A method of forming a pattern, the method comprising:
forming, on an etch target layer, a first hardmask (111) and a first guide layer (121);
forming, on the first guide layer (121), a first photoresist pattern (131) having a plurality of first openings;
performing a first surface treatment (ST1) on regions (121T) of the first guide layer (121) exposed through the plurality of first openings, and removing the first photoresist pattern (131);
forming a first block copolymer layer (141) on the first guide layer (121) after the performing the first surface treatment (ST1) has been performed;
forming a first block pattern (141A) by selectively removing some blocks from a plurality of blocks that are self-assembled through phase separation of the first block copolymer layer (141);
forming a first hardmask pattern (111P) by etching the first hardmask (111) using the first block pattern (141A) as an etch mask, the first hardmask pattern (111P) having a plurality of first line patterns, and removing the first block pattern (141A) and the first guide layer (121);
forming a second hardmask (112) and a third hardmask (113) on the first hardmask pattern (111P), and forming a second guide layer (122) on the third hardmask (113);
forming, on the second guide layer (122), a second photoresist pattern (132) having a plurality of second openings;
performing a second surface treatment (ST2) on regions (122T) of the second guide layer (122) exposed through the plurality of second openings, and removing the second photoresist pattern (132);
forming a second block copolymer layer (142) on the second guide layer (122) after the second surface treatment (ST2) has been performed;
forming a second block pattern (142A) by selectively removing some blocks from a plurality of blocks that are self-assembled through phase separation of the second block copolymer layer (142);
forming a third hardmask pattern (113P) by etching the third hardmask (113) using the second block pattern (142A) as an etch mask, the third hardmask pattern (113P) having a plurality of third line patterns crossing the plurality of first line patterns at a certain angle;
forming a second hardmask pattern (112P) by a process that includes etching the second hardmask (112) using the third hardmask pattern (113P) as an etch mask to form a plurality of second line patterns, wherein the forming the second hardmask pattern (112P) includes forming a mask pattern (MP1) from the first hardmask pattern (111P) and the second hardmask pattern (112P); and
forming a cross pattern by etching the etch target layer using the mask pattern (MP1) as an etch mask.

2. The method of claim 1, wherein
the first hardmask pattern (111P) comprises the plurality of first line patterns and a plurality of first space patterns, which are alternately and repeatedly arranged, and
the plurality of first space patterns correspond to the plurality of first openings.

3. The method of claim 2, wherein
the second hardmask (112) fills the plurality of first space patterns of the first hardmask pattern (111P) and covers the plurality of first line patterns of the first hardmask pattern (111P), and an upper surface of the second hardmask (112) is a flat surface.

4. The method of any preceding claim, wherein the first photoresist pattern (131) and the second photoresist pattern (132) are manufactured using an extreme ultraviolet (EUV) exposure material.

5. The method of claim 4, further comprising:
after the forming the third hardmask pattern (113P), forming a cell open mask (COP) covering a portion of the third hardmask pattern (113P).

6. The method of claim 5, wherein the cell open mask (COP) is manufactured using an i-line exposure material, a krypton fluoride (KrF) exposure material, or an argon fluoride (ArF) exposure material.

7. The method of any preceding claim, wherein the certain angle formed by the plurality of first line patterns and the plurality of third line patterns is greater than 0° and less than 180°.

8. The method of claim 7, wherein
the mask pattern (MP1) comprises a mesh pattern, and
the cross pattern comprises a plurality of hole patterns (101H) having identical repeating units.

9. The method of claim 8, wherein a pitch between the plurality of hole patterns (101H) is in a range of about 12 nanometers (nm) to about 30 nm.

10. The method of claim 9, wherein, in a plan view, the plurality of hole patterns (101H) each have a parallelogram shape.

11. The method of claim 9 or claim 10, wherein the pitch is defined by the first photoresist pattern (131), the second photoresist pattern (132), the plurality of blocks that are self-assembled through phase separation of the first block copolymer layer (141), and the plurality of blocks that are self-assembled through phase separation of the second block copolymer layer (142).

12. The method of claim 1, further comprising:
after the forming the second hardmask pattern (112P), cutting the plurality of first line patterns of the first hardmask pattern (111P) at certain intervals by etching the first hardmask pattern (111P) using the second hardmask pattern (112P) as an etch mask,.

13. The method of claim 12, wherein
the mask pattern (MP1) comprises a plurality of hole patterns (101H) having identical repeating units, and
the cross pattern comprises a mesh pattern.

14. The method of any preceding claim, wherein the first block copolymer layer (141) and the second block copolymer layer (142) each comprise a self-assembly structure in which a plurality of blocks having repeating units of different components are alternately arranged.

15. The method of claim 14, wherein the first block copolymer layer (141) and the second block copolymer layer (142) comprise identical materials.
